# EUROPEAN PATENT APPLICATION

(11) **EP 4 779 693 A1**
(43) Date of publication of application: **22.07.2026**
(21) Application number: 24886021.5
(22) Date of filing: 12.09.2024
(51) Int. Cl.: H01L 25/075, H10H 20/857, H10H 20/85, H10H 20/855, H10H 20/831, H10H 20/852, H10H 20/851

(54) **DISPLAY PANEL COMPRISING INSULATING MEMBER DISPOSED BETWEEN PIXELS**

(30) Priority: 31.10.2023 KR 20230148579; 22.11.2023 KR 20230163802
(71) Applicant: Samsung Electronics Co., Ltd., Suwon-si, Gyeonggi-do 16677 (KR)
(72) Inventor: LEE, Keunsik, Suwon-si Gyeonggi-do 16677 (KR); KIM, Hakyeol, Suwon-si Gyeonggi-do 16677 (KR); PARK, Jaewook, Suwon-si Gyeonggi-do 16677 (KR); SHIN, Jungwoon, Suwon-si Gyeonggi-do 16677 (KR); LEE, Eungyeong, Suwon-si Gyeonggi-do 16677 (KR); CHOI, Junghun, Suwon-si Gyeonggi-do 16677 (KR)
(74) Representative: Gulde & Partner
(86) International application number: PCT/KR2024/013945
(87) International publication number: WO 2025/095343

(57) **Abstract**

A display panel is disclosed. The display panel comprises: a substrate; a switching circuit; a first conductive pad and a second conductive pad connected to the switching circuit; a first electrode connected to the first conductive pad; a first LED including a light-emitting element disposed on the first electrode and a second electrode disposed on the light-emitting element; a second LED including a second electrode connected to the second conductive pad, a light-emitting element disposed on the second electrode, and a second electrode disposed on the light-emitting element; and an insulating member disposed between the first LED and the second LED. The height of the insulating member may be higher than the height of the first conductive pad and lower than the height of the first LED coupled to the first conductive pad. Various other embodiments are possible.

## Description

### [Technical Field]

The present disclosure relates to a display panel including an insulating member disposed between pixels.

### [Background Art]

A display panel may mount a chip (or diode) that configures a pixel on a substrate. In order to inspect whether the mounted chip emits light, methods such as automatic optical inspection (AOI), photoluminescence (PL), and electroluminescence (EL) may be used.

The above-described information may be provided as related art for the purpose of helping the understanding of the present disclosure. No claim or determination is raised as to whether any of the above-described content may be applied as prior art related to the present disclosure.

### [Disclosure]

### [Technical Solution]

According to an embodiment, a display panel may comprise a substrate. The display panel may comprise a switching circuit, and a first conductive pad and a second conductive pad connected to the switching circuit. The switching circuit may be formed on the substrate. The first conductive pad and the second conductive pad may be formed on the substrate. The display panel may comprise a first LED and a second LED. The first LED may include a first electrode connected to the first conductive pad, a light emitting element disposed on the first electrode, and a second electrode disposed on the light emitting element. The second LED may include a second electrode connected to the second conductive pad, a light emitting element disposed on the second electrode, and a second electrode disposed on the light emitting element. The display panel may comprise an insulating member. The insulating member may be disposed between the first LED and the second LED. A height of the insulating member may be greater than a height of the first conductive pad. The height of the insulating member may be lower than a height of the first LED coupled to the first conductive pad 402.

According to an embodiment, a display panel may comprise a substrate. The display panel may comprise a switching circuit and a conductive pad connected to the switching circuit. The switching circuit may be formed on the substrate. The conductive pad may be formed on the substrate. The display panel may comprise an LED. The LED may include a first electrode connected to the conductive pad, a light emitting element disposed on the first electrode, and a second electrode disposed on the light emitting element. The conductive pad may include partial pads spaced apart from each other. The conductive pad may be coupled to the first electrode by a conductive material disposed between the partial pads.

A display panel may comprise a substrate. The display panel may comprise a switching circuit and a conductive pad connected to the switching circuit. The switching circuit may be formed on the substrate. The conductive pad may be formed on the substrate. The display panel may comprise an LED. The LED may include a first electrode connected to the conductive pad, a light emitting element disposed on the first electrode, and a second electrode disposed on the light emitting element. The electronic device may further comprise a non-conductive layer covering a side surface of the first conductive pad and a portion of an upper surface of the first conductive pad.

### [Description of the Drawings]

FIG. 1 is a drawing illustrating an electronic device according to an embodiment.
FIG. 2 is an exploded perspective view of an electronic device according to an embodiment.
FIGS. 3A to 3E illustrate examples of some pixels of an exemplary display device.
FIG. 4 illustrates a cross-sectional view of a portion of an exemplary display device.
FIG. 5 illustrates an example of one of assembly processes of an exemplary display device.
FIG. 6 is a drawing illustrating an exemplary process of mounting an LED element in an assembly process of an exemplary display device.
FIG. 7 is a drawing illustrating an exemplary process of mounting an LED element having an electrode of a concave-convex shape in an assembly process of an exemplary display device.
FIG. 8 is a drawing illustrating an exemplary process of performing a lighting inspection during an assembly process of an exemplary display device.
FIG. 9 is a drawing illustrating an exemplary display device including a patterned pad connected to a switching circuit.
FIG. 10 is a drawing illustrating an exemplary process of welding an exemplary patterned pad.
FIG. 11 illustrates an arrangement with a pattern protruding from a jig for a lighting inspection, which is inserted between exemplary patterned pads.
FIG. 12 is a drawing illustrating an exemplary process of performing a lighting inspection during assembly of a display device including an exemplary patterned pad.
FIG. 13 is a drawing illustrating an exemplary process of performing a lighting inspection during assembly of a display device including a substrate having an exemplary insulating portion.
FIG. 14 is a drawing illustrating an exemplary process of performing a lighting inspection during assembly of a display device using a jig having an exemplary insulating portion.
FIG. 15 is a drawing illustrating an assembly process of a display device using an exemplary insulating portion.
FIG. 16A is a drawing illustrating an arrangement of an exemplary insulating portion of a display device.
FIG. 16B is a drawing illustrating a state during assembly of a display device using an additional insulating portion disposed on an exemplary insulating portion.
FIG. 17 is a block diagram of an electronic device in a network environment according to various embodiments.
FIG. 18 is a block diagram of a display module according to various embodiments.
FIG. 19A illustrates an example of a perspective view of a wearable device according to an embodiment.
FIG. 19B illustrates an example of one or more hardware disposed in a wearable device according to an embodiment.
FIGS. 20A and 20B illustrate an example of an exterior of a wearable device according to an embodiment.

### [Mode for Invention]

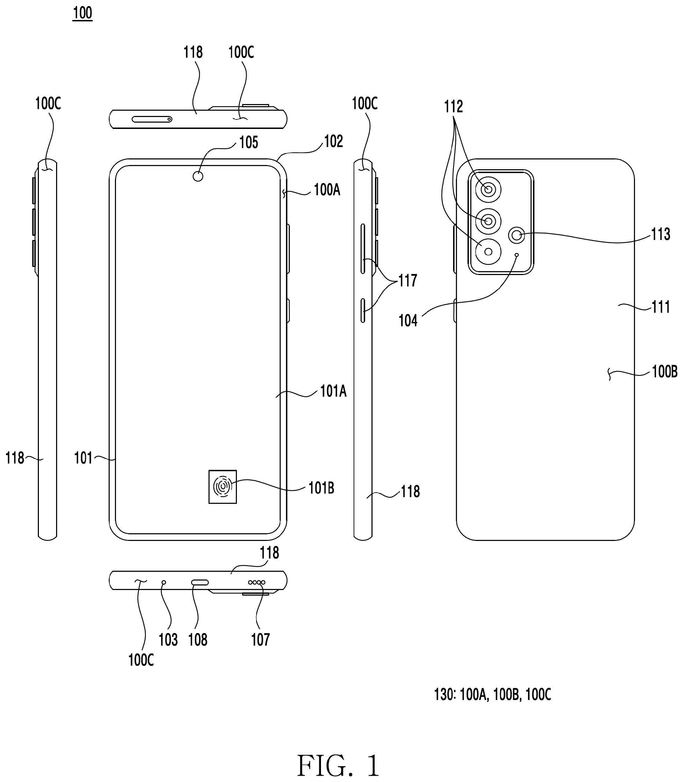

FIG. 1 is a drawing illustrating an electronic device according to an embodiment.

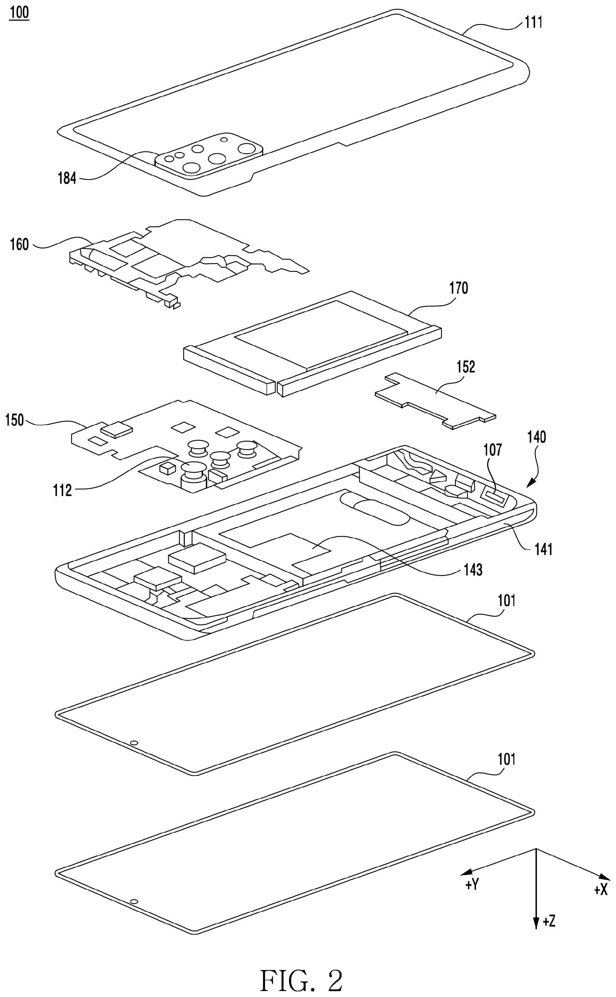

Referring to FIG. 1, an electronic device 100 according to an embodiment may include a housing 110 forming an exterior of the electronic device 100. For example, the housing 110 may include a first surface (or a front surface) 100A, a second surface (or a rear surface) 100B, and a third surface (or a side surface) 100C surrounding a space between the first surface 100A and the second surface 100B. In an embodiment, the housing 110 may also refer to a structure (e.g., a frame structure 140 of FIG. 2) forming at least a portion of the first surface 100A, the second surface 100B, and/or the third surface 100C.

The electronic device 100 according to an embodiment may include a substantially transparent front plate 102. In an embodiment, the front plate 102 may form at least a portion of the first surface 100A. In an embodiment, the front plate 102 may include, for example, a glass plate or a polymer plate including various coating layers, but is not limited thereto.

The electronic device 100 according to an embodiment may include a substantially opaque rear plate 111. In an embodiment, the rear plate 111 may form at least a portion of the second surface 100B. In an embodiment, the rear plate 111 may be formed of coated or colored glass, ceramic, polymer, metal (e.g., aluminum, stainless steel (STS), or magnesium), or a combination of at least two of the materials.

The electronic device 100 according to an embodiment may include a side bezel structure (or a side member) 118 (e.g., a sidewall 141 of the frame structure 140 of FIG. 2). In an embodiment, the side bezel structure 118 may form at least a portion of the third surface 100C of the electronic device 100 by being coupled to the front plate 102 and/or the rear plate 111. For example, the side bezel structure 118 may form the entirety of the third surface 100C of the electronic device 100, or for another example, the side bezel structure 118 may form the third surface 100C of the electronic device 100 together with the front plate 102 and/or the rear plate 111.

Unlike the illustrated embodiment, when the third surface 100C of the electronic device 100 is partially formed by the front plate 102 and/or the rear plate 111, the front plate 102 and/or the rear plate 111 may include a region that bends at an edge thereof toward the rear plate 111 and/or the front plate 102 and extends seamlessly. The extending region of the front plate 102 and/or the rear plate 111 may be positioned, for example, at both ends of a long edge of the electronic device 100, but is not limited to the above-described example.

In an embodiment, the side bezel structure 118 may include metal and/or polymer. In an embodiment, the rear plate 111 and the side bezel structure 118 may be integrally formed and may include the same material (e.g., a metal material such as aluminum), but are not limited thereto. For example, the rear plate 111 and the side bezel structure 118 may be formed as separate components and/or may include different materials.

In an embodiment, the electronic device 100 may include at least one of a display 101, an audio module 103, 104, and 107, a sensor module (not illustrated), a camera module 105, 112, and 113, a key input device 117, a light emitting element (not illustrated), and/or a connector hole 103. In another embodiment, the electronic device 100 may omit at least one (e.g., the key input device 117 or the light emitting element (not illustrated)) of the components or may additionally include another component.

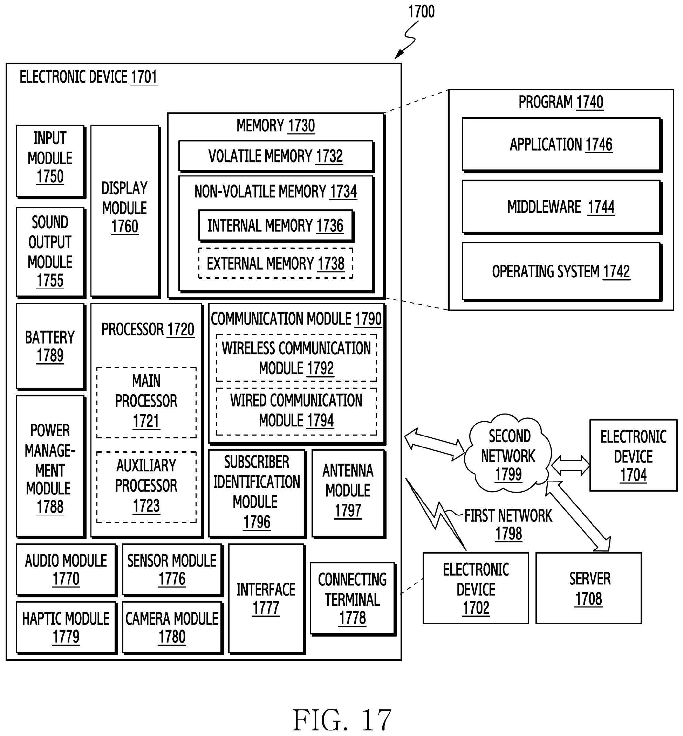

In an embodiment, the display 101 (e.g., a display module 1760 of FIG. 17) may be visually exposed through a substantial portion of the front plate 102. For example, at least a portion of the display 101 may be visible through the front plate 102 forming the first surface 100A. In an embodiment, the display 101 may be disposed on a rear surface of the front plate 102.

In an embodiment, an outer shape of the display 101 may be formed to be substantially the same as an outer shape of the front plate 102 adjacent to the display 101. In an embodiment, to expand an area visually exposed by the display 101, a gap between an outer edge of the display 101 and an outer edge of the front plate 102 may be formed to be substantially the same.

In an embodiment, the display 101 (or the first surface 100A of the electronic device 100) may include a screen display area 101A. In an embodiment, the display 101 may provide visual information to a user through the screen display area 101A. In the illustrated embodiment, when the first surface 100A is viewed from the front, the screen display area 101A is illustrated as being spaced apart from an outer edge of the first surface 100A and positioned inside the first surface 100A, but is not limited thereto. In another embodiment, when the first surface 100A is viewed from the front, at least a portion of an edge of the screen display area 101A may substantially coincide with an edge of the first surface 100A (or the front plate 102).

In an embodiment, the screen display area 101A may include a sensing area 101B configured to obtain biometric information of a user. Herein, the meaning of "the screen display area 101A includes the sensing area 101B" may be understood as at least a portion of the sensing area 101B being overlapped with the screen display area 101A. For example, the sensing area 101B may display visual information by the display 101 like other areas of the screen display area 101A, and additionally may mean an area capable of obtaining biometric information (e.g., a fingerprint) of the user. In another embodiment, the sensing area 101B may be formed in the key input device 117.

In an embodiment, the display 101 may include an area in which a first camera module 105 (e.g., a camera module 1780 of FIG. 17) is positioned. In an embodiment, an opening may be formed in the area of the display 101, and the first camera module 105 (e.g., a punch-hole camera) may be at least partially disposed in the opening to face the first surface 100A. In this case, the screen display area 101A may surround at least a portion of an edge of the opening. In another embodiment, the first camera module 105 (e.g., an under display camera (UDC)) may be disposed below the display 101 to overlap the area of the display 101. In this case, the display 101 may provide visual information to the user through the area, and additionally, the first camera module 105 may obtain an image corresponding to a direction toward the first surface 100A through the area of the display 101.

In an embodiment, the display 101 may be coupled with or disposed adjacent to touch sensing circuitry, a pressure sensor capable of measuring touch intensity (pressure), and/or a digitizer detecting a magnetic-field-based stylus pen.

In an embodiment, the audio module 103, 104, and 107 (e.g., an audio module 1770 of FIG. 17) may include microphone holes 103 and 104 and a speaker hole 107.

In an embodiment, the microphone holes 103 and 104 may include a first microphone hole 103 formed in a partial area of the third surface 100C and a second microphone hole 104 formed in a partial area of the second surface 100B. Inside the microphone holes 103 and 104, a microphone (not illustrated) for obtaining external sound may be disposed. The microphone may include a plurality of microphones to detect a direction of sound.

In an embodiment, the second microphone hole 104 formed in a partial area of the second surface 100B may be disposed adjacent to the camera module 105, 112, and 113. For example, the second microphone hole 104 may obtain sound according to an operation of the camera module 105, 112, and 113. However, it is not limited thereto.

In an embodiment, the speaker hole 107 may include an external speaker hole 107 and a receiver hole (not illustrated) for calls. The external speaker hole 107 may be formed in a portion of the third surface 100C of the electronic device 100. In another embodiment, the external speaker hole 107 may be implemented as one hole with the microphone hole 103. Although not illustrated, the receiver hole (not illustrated) for calls may be formed in another portion of the third surface 100C. For example, the receiver hole for calls may be formed on an opposite side of the external speaker hole 107 in the third surface 100C. For example, based on the illustration of FIG. 1, the external speaker hole 107 may be formed on the third surface 100C corresponding to a lower end portion of the electronic device 100, and the receiver hole for calls may be formed on the third surface 100C corresponding to an upper end portion of the electronic device 100. However, it is not limited thereto, and in another embodiment, the receiver hole for calls may be formed at a position other than the third surface 100C. For example, the receiver hole for calls may be formed by a spaced space between the front plate 102 (or the display 101) and the side bezel structure 118.

In an embodiment, the electronic device 100 may include at least one speaker (not illustrated) configured to output sound to the outside of the housing 110 through the external speaker hole 107 and/or the receiver hole for calls (not illustrated).

In an embodiment, the sensor module (not illustrated) (e.g., a sensor module 1776 of FIG. 17) may generate an electrical signal or a data value corresponding to an internal operating state of the electronic device 100 or an external environmental state. For example, the sensor module may include at least one of a proximity sensor, an HRM sensor, a fingerprint sensor, a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, or an illuminance sensor.

In an embodiment, the camera module 105, 112, and 113 (e.g., the camera module 1780 of FIG. 17) may include a first camera module 105 disposed to face the first surface 100A of the electronic device 100, a second camera module 112 disposed to face the second surface 100B, and a flash 113.

In an embodiment, the second camera module 112 may include a plurality of cameras (e.g., a dual camera, a triple camera, or a quad camera). However, the second camera module 112 is not necessarily limited to including a plurality of cameras and may include one camera.

In an embodiment, the first camera module 105 and the second camera module 112 may include one or a plurality of lenses, an image sensor, and/or an image signal processor.

In an embodiment, the flash 113 may include, for example, a light emitting diode or a xenon lamp. In another embodiment, two or more lenses (an infrared camera, wide-angle lens, and telephoto lens) and image sensors may be disposed on one surface of the electronic device 100.

In an embodiment, the key input device 117 (e.g., an input module 1750 of FIG. 17) may be disposed on the third surface 100C of the electronic device 100. In another embodiment, the electronic device 100 may not include some or all of the key input devices 117, and the key input device 117 not included may be implemented in another form such as a soft key on the display 101.

In an embodiment, the connector hole 103 may be formed in the third surface 100C of the electronic device 100 such that a connector of an external device may be accommodated. Inside the connector hole 103, a connecting terminal (e.g., a connecting terminal 1778 of FIG. 17) electrically connected to the connector of the external device may be disposed. The electronic device 100 according to an embodiment may include an interface module (e.g., an interface 1777 of FIG. 17) for processing an electrical signal transmitted and received through the connection terminal.

In an embodiment, the electronic device 100 may include a light emitting element (not illustrated). For example, the light emitting element (not illustrated) may be disposed on the first surface 100A of the housing 110. The light emitting element (not illustrated) may provide state information of the electronic device 100 in a form of light. In another embodiment, the light emitting element (not illustrated) may provide a light source linked to an operation of the first camera module 105. For example, the light emitting element (not illustrated) may include an LED, an IR LED, and/or a xenon lamp.

FIG. 2 is an exploded perspective view of an electronic device according to an embodiment.

Hereinafter, redundant descriptions of a configuration having the same reference numerals as those of the above-described configuration will be omitted..

Referring to FIG. 2, an electronic device 100 according to an embodiment may include a frame structure 140, a first printed circuit board 150, a second printed circuit board 152, a cover plate 160, and a battery 170.

In an embodiment, the frame structure 140 may include a sidewall 141 forming an exterior (e.g., a third surface 100C of FIG. 2) of the electronic device 100 and a support portion 143 extending inward from the sidewall 141. In an embodiment, the frame structure 140 may be disposed between a display 101 and a rear plate 111. In an embodiment, the sidewall 141 of the frame structure 140 may surround a space between the rear plate 111 and a front plate 102 (and/or the display 101), and the support portion 143 of the frame structure 140 may extend from the sidewall 141 within the space. According to an embodiment, the sidewall 141 forming a side surface (e.g., the side surface 100C of FIG. 2) of the electronic device 100 may include a speaker hole 107 connecting an inside and an outside of the electronic device 100. The speaker hole 107 may penetrate the sidewall 141.

In an embodiment, the frame structure 140 may support or accommodate another component included in the electronic device 100. For example, the display 101 may be disposed on a surface of the frame structure 140 facing a direction (e.g., a +z direction), and the display 101 may be supported by the support portion 143 of the frame structure 140. For another example, the first printed circuit board 150, the second printed circuit board 152, the battery 170, and a second camera module 112 may be disposed on another surface of the frame structure 140 facing a direction (e.g., a -z direction) opposite to the direction. The first printed circuit board 150, the second printed circuit board 152, the battery 170, and the second camera module 112 may each be seated in a recess defined by the sidewall 141 and/or the support portion 143 of the frame structure 140.

In an embodiment, the first printed circuit board 150, the second printed circuit board 152, and the battery 170 may be respectively coupled to the frame structure 140. For example, the first printed circuit board 150 and the second printed circuit board 152 may be fixedly disposed on the frame structure 140 through a coupling member such as a screw. For example, the battery 170 may be fixedly disposed on the frame structure 140 through an adhesive member (e.g., a double-sided tape). However, it is not limited by the above-described example.

In an embodiment, the cover plate 160 may be disposed between the first printed circuit board 150 and the rear plate 111. In an embodiment, the cover plate 160 may be disposed on the first printed circuit board 150. For example, the cover plate 160 may be disposed on a surface of the first printed circuit board 150 facing the -z direction.

In an embodiment, the cover plate 160 may at least partially overlap the first printed circuit board 150 with respect to a z-axis. In an embodiment, the cover plate 160 may cover at least a portion of an area of the first printed circuit board 150. Through this, the cover plate 160 may protect the first printed circuit board 150 from physical impact or may prevent detachment of a connector coupled to the first printed circuit board 150.

In an embodiment, the cover plate 160 may be fixedly disposed on the first printed circuit board 150 through a coupling member (e.g., a screw) or may be coupled to the frame structure 140 together with the first printed circuit board 150 through the coupling member.

In an embodiment, the display 101 may be disposed between the frame structure 140 and the front plate 102. For example, the front plate 102 may be disposed on one side (e.g., the +z direction) of the display 101, and the frame structure 140 may be disposed on another side (e.g., the -z direction).

In an embodiment, the front plate 102 may be coupled to the display 101. For example, the front plate 102 and the display 101 may be adhered to each other through an optical adhesive member (e.g., an optically clear adhesive (OCA) or an optically clear resin (OCR)) interposed therebetween.

In an embodiment, the front plate 102 may be coupled to the frame structure 140. For example, when viewed in the z-axis direction, the front plate 102 may include an outer portion extending beyond the display 101 and may be adhered to the frame structure 140 (e.g., the sidewall 141) through an adhesive member (e.g., a double-sided tape) disposed between the outer portion of the front plate 102 and the frame structure 140. However, it is not limited to the above-described example.

In an embodiment, a processor (e.g., a processor 1720 of FIG. 17), memory (e.g., memory 1730 of FIG. 17), and/or an interface (e.g., an interface 1777 of FIG. 17) may be mounted on the first printed circuit board 150 and/or the second printed circuit board 152. The processor may include, for example, one or more of a central processing unit, an application processor, a graphics processing unit, an image signal processor, a sensor hub processor, or a communication processor. The memory may include, for example, a volatile memory or a non-volatile memory. The interface may include, for example, a high definition multimedia interface (HDMI), a universal serial bus (USB) interface, an SD card interface, and/or an audio interface. The interface may electrically or physically connect the electronic device 100 to an external electronic device, and may include a USB connector, an SD card/MMC connector, or an audio connector. In an embodiment, the first printed circuit board 150 and the second printed circuit board 152 may be operatively or electrically connected to each other through a connecting member (e.g., a flexible printed circuit board).

In an embodiment, the battery 170 (e.g., a battery 1789 of FIG. 17) may supply power to at least one component of the electronic device 100. For example, the battery 170 may include a rechargeable secondary cell or a fuel cell. At least a portion of the battery 170 may be disposed on substantially the same plane as the first printed circuit board 150 and/or the second printed circuit board 152.

The electronic device 100 according to an embodiment may include an antenna module (not illustrated) (e.g., an antenna module 1797 of FIG. 17). In an embodiment, the antenna module may be disposed between the rear plate 111 and the battery 170. The antenna module may include, for example, a near field communication (NFC) antenna, a wireless charging antenna, and/or a magnetic secure transmission (MST) antenna. The antenna module may perform, for example, short-range communication with an external device or may wirelessly transmit and receive power with an external device.

In an embodiment, a first camera module 105 (e.g., a front camera) may be disposed in at least a portion (e.g., the support portion 143) of the frame structure 140 such that a lens may receive external light through a partial area of the front plate 102 (e.g., a front surface 100A of FIG. 2).

In an embodiment, the second camera module 112 (e.g., a rear camera) may be disposed between the frame structure 140 and the rear plate 111. In an embodiment, the second camera module 112 may be electrically connected to the first printed circuit board 150 through a connecting member (e.g., a connector). In an embodiment, the second camera module 112 may be disposed such that a lens may receive external light through a camera area 184 of the rear plate 111 of the electronic device 100.

In an embodiment, the camera area 184 may be formed on a surface of the rear plate 111 (e.g., a rear surface 100B of FIG. 2). In an embodiment, the camera area 184 may be formed to be at least partially transparent such that external light may be incident on the lens of the second camera module 112. In an embodiment, at least a portion of the camera area 184 may protrude from the surface of the rear plate 111 by a predetermined height. However, it is not limited thereto, and in another embodiment, the camera area 184 may form substantially the same plane as the surface of the rear plate 111.

In an embodiment, a housing 110 of the electronic device 100 may refer to a component or a structure forming at least a portion of the exterior of the electronic device 100. In this regard, at least a portion of the front plate 102, the frame structure 140, and/or the rear plate 111 forming the exterior of the electronic device 100 may be referred to as the housing 110 of the electronic device 100.

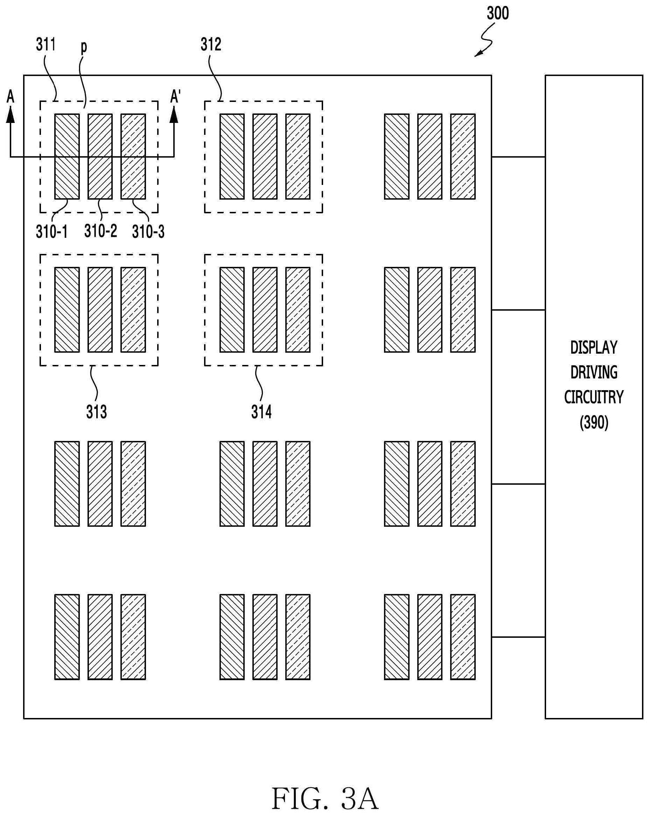

FIGS. 3A to 3E illustrate examples of some pixels of an exemplary display device.

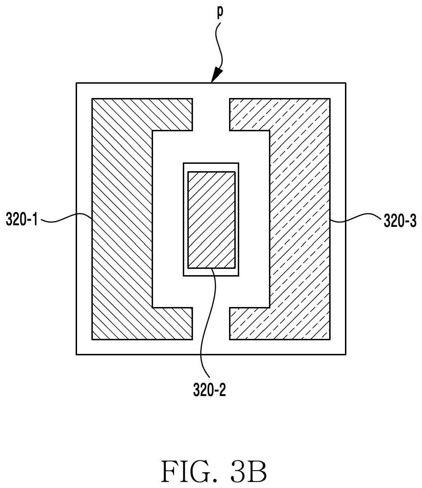

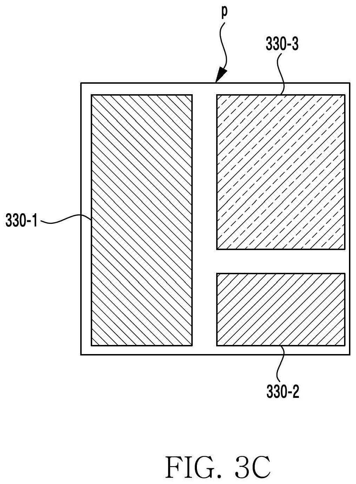

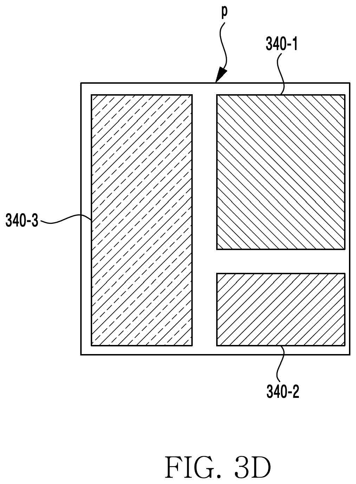

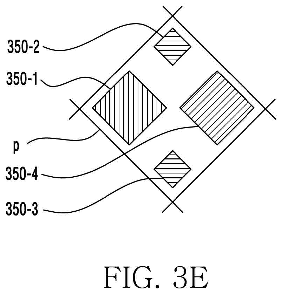

Referring to FIGS. 3A, 3B, 3C, 3D, and 3E, a display device 300 may include a display panel 301 including pixels P and display driving circuitry 390. The display device 300 may be referred to as a display module. A pixel P may be one unit that emits light.

Referring to FIG. 3A, each of pixels 311, 312, 313, and 314 may include a plurality of subpixels 310-1, 310-2, and 310-3. Each of the plurality of subpixels 310-1, 310-2, and 310-3 may provide a designated color. For example, a first subpixel 310-1 among each of pixels 310 may provide red light, a second subpixel 310-2 among each of the pixels 310 may provide blue light, and a third subpixel 310-3 among each of the pixels 310 may provide green light. An arrangement scheme of the pixels may be an RGB arrangement scheme. The RGB scheme may be a scheme of arranging one red, one green, and one blue subpixel. Sizes of the first subpixel 310-1, the second subpixel 310-2, and the third subpixel 310-3 may be the same or similar. An arrangement of respective subpixels within a pixel P may be disposed in an order of the first subpixel 310-1, the second subpixel 310-3, and a third subpixel 310-4. However, it is not limited thereto, and the subpixels may be disposed in another arrangement. For example, the subpixels may be arranged in an order of the first subpixel 310-1 emitting red light, the third subpixel 310-3 emitting green light, and the second subpixel 310-2 emitting blue light. The plurality of subpixels 310-1, 310-2, and 310-3 may be distinguished by a pixel define member or a light blocking member formed inside the display device 300. The pixels 311, 312, 313, and 314 and other pixels disposed on one panel may have substantially the same subpixel arrangement structure as described above.

An electronic device 100 (e.g., the electronic device 100 of FIG. 1) may provide visual information through the display device 300. The visual information may include still images (or an image) and/or moving images. The electronic device 100 may display broadcast content, multimedia content, or a stored document or photograph in the electronic device 100 on the display device 300. The display device 300 may display a video based on a video signal received from a processor through the display driving circuitry 390. For example, the display driving circuitry 390 may generate a driving signal of the subpixels 310-1, 310-2, and 310-3 based on the video signal. The display driving circuitry 390 may control light emission of the subpixels 310-1, 310-2, and 310-3 based on the driving signal. The display driving circuitry 390 may display visual information on the display device 300 by controlling the light emission.

Referring to FIGS. 3B, 3C, and 3D, an arrangement of subpixels within a pixel P may vary.

Efficiency of blue light emitted through a second subpixel 320-2, 330-2, or 340-2 may be higher than efficiency of light emitted through other subpixels, and the emitted light may be stable. Based on high efficiency and stability of the second subpixel 320-2, 330-2, or 340-2 emitting blue light, the second subpixel 320-2, 330-2, or 340-2 emitting blue light among the subpixels may have a smaller area than other subpixels.

Referring to FIG. 3B, a first subpixel 320-1, a second subpixel 320-2, and a third subpixel 320-3 may be sequentially disposed. Areas of the first subpixel 320-1 emitting red light and the third subpixel 320-3 emitting green light may be substantially the same and may be larger than an area of the second subpixel 320-2.

Referring to FIGS. 3C and 3D, a first subpixel 330-1 or 340-1, a second subpixel 330-2 or 340-2, and a third subpixel 330-3 or 340-3 may occupy regions having different areas within a pixel P. The second subpixel 330-2 or 340-2 emitting blue light may be disposed in a region having the smallest area, and the first subpixel 330-1 or 340-1 emitting red light or the third subpixel 330-2 or 340-2 emitting green light may be disposed in regions having different areas.

Referring to FIG. 3E, a pixel P may include a plurality of subpixels 350-1, 350-2, 350-3, and 350-4. Each of the plurality of subpixels 350-1, 350-2, 350-3, and 350-4 may provide a designated color. For example, a first subpixel 350-1 among each of pixels 350 may provide red light, a second subpixel 350-2 and a third subpixel 350-3 among each of the pixels 350 may provide green light, and a fourth subpixel 350-4 among each of the pixels 350 may provide blue light. An arrangement scheme of the pixel may be a Pentile RGBG scheme. The Pentile RGBG scheme may be a scheme of arranging the number of red, green, and blue subpixels in a ratio of 1:2:1. Sizes of the first subpixel 350-1 and the fourth subpixel 350-4 may be the same or similar. The second subpixel 350-2 and the third subpixel 350-3 may have a smaller size than the first subpixel 350-1 and the fourth subpixel 350-4. The arrangement of respective subpixels within the pixels 350 may be disposed in an order of the first subpixel 350-1, the third subpixel 350-3, the fourth subpixel 350-4, and the second subpixel 350-2 in a clockwise direction.

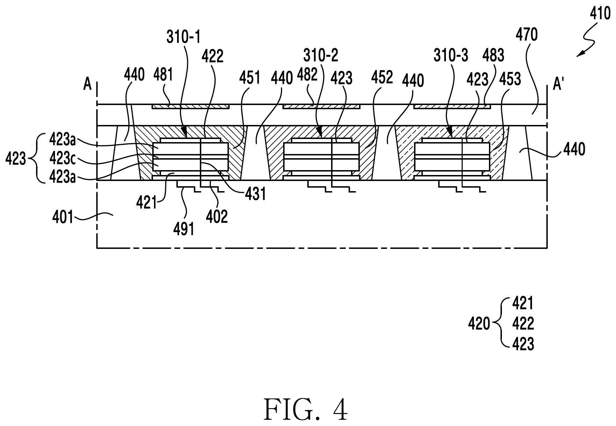

FIG. 4 illustrates a cross-sectional view of a portion of an exemplary display panel.

Referring to FIG. 4, a display panel 410 may include a substrate 401, an LED 420, and/or an insulating member 440. The display panel 410 in a display device (e.g., the display device 300 of FIG. 3A) may include the substrate 401 and a plurality of subpixels 310-1, 310-2, and 310-3 disposed on the substrate 401. The display panel 410 will be described based on a cross-section of the display device 300 of FIG. 3A cut along line A-A'.

The substrate 401 may include a transparent material or a translucent material. The substrate 401 may include a glass material or a polymer material. The polymer may include polyimide (PI), polyethylene terephthalate (PET), or polycarbonate (PC).

The substrate 401 may include a switching circuit (e.g., a thin film transistor (TFT)) 491. The TFT may include an LTPS TFT, an oxide TFT, an a-Si TFT, an organic TFT, or a graphene TFT.

Subpixels 310-1, 310-2, and 310-3 may be disposed on the substrate 401. Each of the subpixels 310-1, 310-2, and 310-3 may include a light emitting diode (LED) 420. The LED 420 may include a first electrode 421, a second electrode 422, and a light emitting element 423.

The first electrode 421 may be bonded to a conductive pad 402 exposed from the substrate 401. The light emitting element 423 may be disposed on the first electrode 421. The second electrode 422 may be disposed on the light emitting element 423. The LED 420 may be referred to as a vertical LED or a vertical LED chip in terms of electrodes being vertically disposed.

The first electrode 421 may be connected to the switching circuit 491 through bonding with the conductive pad 402. The second electrode 422 may be connected to the switching circuit 491. The second electrode 422 may contact a conductive line 431 connected to the second electrode 422 and extending along a side surface of the light emitting element 423 toward the switching circuit 491. The conductive line 431 may be insulated except for a portion contacting the second electrode 422. The second electrode 422 may be electrically connected to the switching circuit 491 through the conductive line 431. However, it is not limited thereto, and the second electrode 422 may be connected to the switching circuit 491 through a wire or another conductive material. The conductive line 431 may be directly connected to an exposed portion of the switching circuit 491 or may be bonded to a conductive pad connected to the switching circuit 491.

The display panel 410 may include the insulating member 440 surrounding each of the subpixels 310-1 and 310-3. The insulating member 440 may be a partition wall extending spaced apart from each of the subpixels 310-1 and 301-3. The insulating member 440 may be disposed on the substrate 401 and may form a grid. The insulating member 440 forming the grid may define a plurality of cells. A cell formed on the substrate 401 by the insulating member 440 may be an area in which each of pixels 310-1, 301-2, 301-3, and 301-4 is disposed. The insulating member 440 may be referred to as a pixel define layer (PDL) in terms of defining areas in which pixels 310-1, 310-2, 310-3, and 310-4 are disposed. The insulating member 440 may include an insulating material and may include a light blocking material.

An LED 420 may be disposed in each of cells distinguished by the insulating member 440. In a placement process of the insulating member 440, after the LED 420 is mounted, the insulating member 440 may be disposed to surround the LED 420. However, it is not limited thereto, and the insulating member 440 may be disposed on the substrate 401 first, and then the LED 420 may be mounted in a cell. Color conversion materials 451, 452, and 453 may be filled in the cell in which the LED 420 is mounted. The insulating member 440 surrounds the pixels 310-1, 310-2, and 310-3 and may be referred to as a dam or a bank in terms of accommodating the color conversion materials 451, 452, and 453. The color conversion materials 451, 452, and 453 may convert a color of light emitted from the LED 420. A first color conversion material 451 may surround the LED 420 included in the first subpixel 310-1. The first color conversion material 451 may have an energy level increased to an excited state by light energy emitted from the light emitting element 423 in the first subpixel 310-1. The first color conversion material 451 may include a material that emits light in a red wavelength band in the excited state. The first subpixel 310-1 may emit red light to the outside.

A transparent material 452 may surround the LED 420 included in the second subpixel 310-2. The second subpixel 310-2 may include the transparent material 452 to emit blue light to the outside. Blue wavelength band light emitted from the LED of the second subpixel 310-2 may transmit through the transparent material 452 including a transparent substance and be emitted to the outside.

A second color conversion material 453 may surround the LED 420 included in the third subpixel 310-3. The second color conversion material 453 may include a material that emits light in a green wavelength band in an excited state by light energy.

The light emitting elements disposed in each of the subpixels 310-1, 310-2, and 310-3 may emit light in the blue wavelength band. Although the light emitting elements disposed in the subpixels 310-1, 310-2, and 310-3 have been described as blue light emitting elements, it is not limited thereto. For example, a light emitting element disposed in the first subpixel 310-1 may emit light in a red wavelength band, and the first color conversion material 451 may include a transparent material. A light emitting element disposed in the second subpixel 310-2 may emit light in the blue wavelength band and may include the transparent material 452 filling the second subpixel 310-2. A light emitting element disposed in the third subpixel 310-3 may emit light in a green wavelength band, and the second color conversion material 453 filling the third subpixel 310-3 may include a transparent material.

The light emitting element 423 may include a p-type semiconductor layer 423a, an n-type semiconductor layer 423b, and a light emitting layer 423c. The p-type semiconductor layer 423a may contact the first electrode 421, and the n-type semiconductor layer 432b may contact the second electrode 422. The p-type semiconductor layer 423a may include one of GaN, AlGaN, InGaN, InAlGaN, AlN, InN, or AlInN, and may be doped with a p-type dopant such as Mg, Zn, Ca, Sr, and Ba. The n-type semiconductor layer 432b may include one of GaN, AlGaN, InGaN, InAlGaN, AlN, InN, or AlInN, and may be doped with an n-type dopant such as Si, Ge, and Sn. Holes and electrons may move through the semiconductor layers 423a and 423b, and holes and electrons may combine in the light emitting layer 423c to generate light. The emitted light may be transmitted toward the color conversion materials 451, 452, and 453. A conductive material in the second electrode 422 and the conductive line 431 may be configured to transmit light emitted from the light emitting element 423. The second electrode 422 may include a transparent electrode such that light emitted from the light emitting layer 423c is not obstructed by the second electrode 422. The transparent electrode may include a thin film that is transparent to visible light and has electrical conductivity. The transparent electrode may include indium Tin oxide (ITO). For example, the transparent electrode may be an electrode in which indium oxide (In₂O₃) or tin oxide (SnO₂) is deposited on PET, which is a polymer material.

The display panel 410 may further include an encapsulate layer 470 disposed on the color conversion materials 451, 452, and 453. The encapsulate layer 470 may include a multilayer structure including one or more inorganic layers and organic layers. The encapsulate layer 470 may protect the subpixels 310-1, 310-2, and 310-3 from external impact. The encapsulate layer 470 may prevent internal elements of the display panel 410 from being oxidized. The encapsulate layer 470 may transmit light emitted from the subpixels 310-1, 310-2, and 310-3. The encapsulate layer 470 may be formed of a material capable of minimizing influence of light transmittance, reflectance, or refractive index. The display panel 410 may further include a transparent layer and/or a window on the encapsulate layer 470. The transparent layer or window may protect the display panel 410 from external impact.

The display panel 410 may further include color filters 481, 482, and 483. The color filters 481, 482, and 483 may be disposed in a layer form. The color filters 481, 482, and 483 may improve color clarity and color reproduction of an image provided through the display panel 410. The color filters 481, 482, and 483 may cover the first subpixel 310-1, the second subpixel 310-2, the third subpixel 310-3, and a portion of the insulating member 440. The color filters 481, 482, and 483 may be disposed on the encapsulate layer 470. The color filters 481, 482, and 483 may be disposed on a window or a transparent layer disposed on the encapsulate layer 470. The color filters 481, 482, and 483 may be configured of filters corresponding to the color conversion materials 451 and 453 and the transparent material 452. For example, the first color filter 481 may selectively transmit red light emitted through the first color conversion material 451, the second color filter 482 may selectively transmit blue light emitted from the light emitting element 423 of the second subpixel 310-2 and transmitted through the transparent material 452, and may selectively transmit green light emitted through the second color conversion material 453.

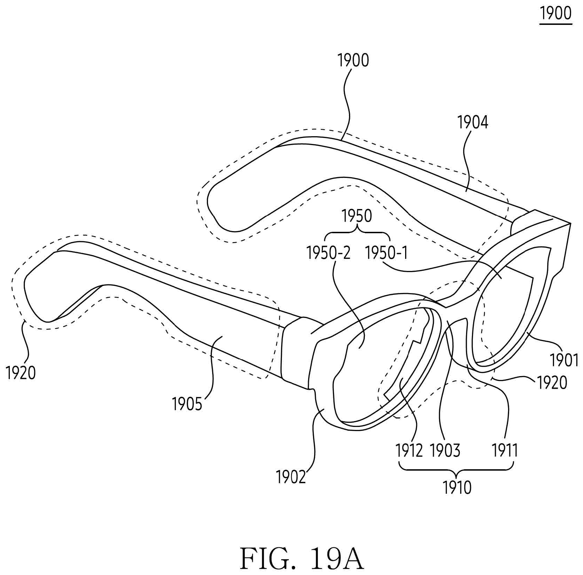

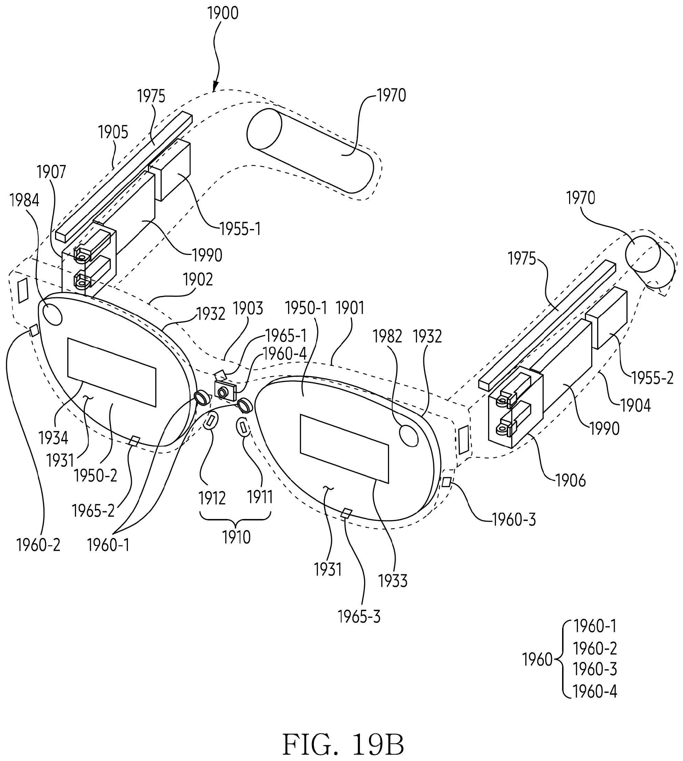

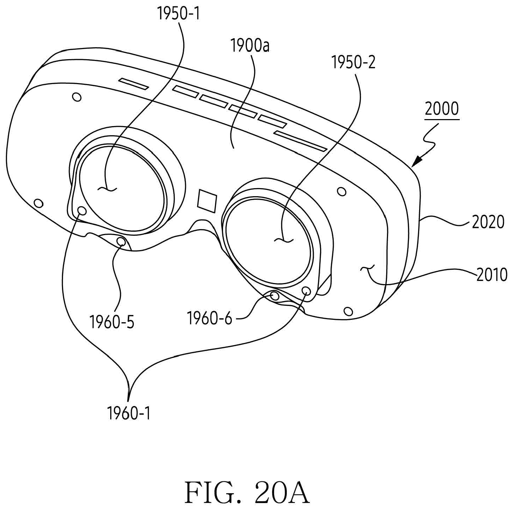

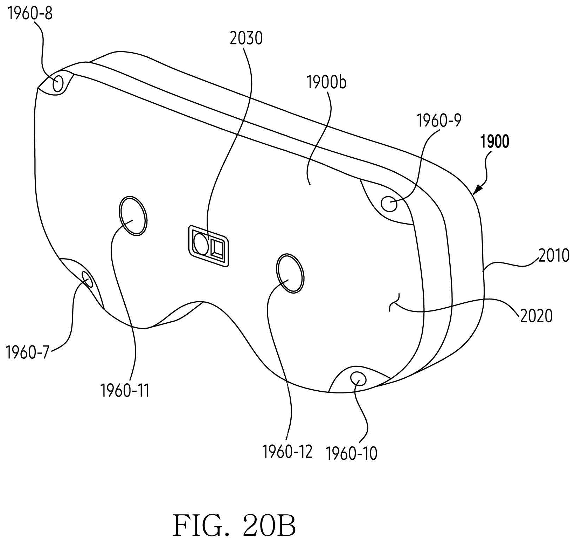

A display device (e.g., the display device 300 of FIG. 3A) including the display panel 410 may be referred to as an LED display panel or a micro LED display panel in terms of including an LED or a micro LED. The micro LED display panel may integrate a large number of LED elements in a small area, thereby enabling application to a display of a wearable device (a wearable device 1900 of FIG. 19A or 19B or a wearable device 2000 of FIGS. 20A and 20B to be described below) for augmented reality (AR) or virtual reality (VR) requiring a high integration density. The micro LED display panel may satisfy high luminance required in AR or VR. The micro LED display panel may provide the effect of improving portability of an electronic device and increasing usage time with low power consumption.

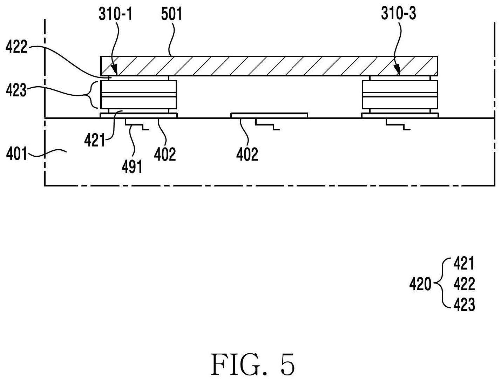

FIG. 5 illustrates an example of one of assembly processes of an exemplary display device.

Referring to FIG. 5, for a lighting inspection of a display panel in which an LED 420 is disposed on a substrate 401, a conductive jig 501 may be disposed on the LED 420. The conductive jig 501 may be disposed to contact a second electrode 422 of the LED 420. For example, during the lighting inspection, the conductive jig 501 may be supported by the LED 420. The conductive jig 501 may contact the second electrode 422 of the LED 420 and apply voltage to a first electrode 421 and the second electrode 422. Based on the voltage applied to the first electrode 421 and the second electrode 422, a light emitting element 423 may emit light. The conductive jig 501 may include a transparent conductive material for the lighting inspection. A material of the conductive jig 501 may be the same as or similar to a material of the second electrode 422. The conductive jig 501 may include indium tin oxide (ITO). For example, the conductive jig 501 may be an electrode in which indium oxide (In₂O₃) or tin oxide (SnO₂) is deposited on PET, which is a polymer material. The conductive jig 501 may include a plate formed of a metal material in a mesh shape. The conductive jig 501 having an opaque metal material in a mesh shape or including a transparent conductive material may transmit light emitted from the LED 420. Based on the transmitted light, a defect inspection of a display panel 410 may be performed.

A height of the LED 420 may be several micrometers, and a width of the LED 420 may be within 100 micrometers. In terms of having a size in a micrometer unit, the LED 420 may be referred to as a micro LED.

The LED 420 may be individually transferred onto the substrate 401, and the LED 420 may be bonded to a conductive pad 402. An LED 420 for which bonding is not completed may detach from the conductive pad 402 on the substrate 401. A deviated conductive pad 403 may be visually exposed to the outside. For example, LEDs 420 of a first subpixel 310-1 and a third subpixel 310-3 may be disposed on the substrate 401, but an LED 420 of a second subpixel 310-2 may be detached and be visually exposed to the outside. Through light emitted from an area in which the LED 420 of the first subpixel 310-1 and the LED 420 of the third subpixel 310-3 are disposed by the conductive jig 501, an inspector may determine that the LEDs 420 configuring the first subpixel 310-1 and the third subpixel 310-3 are normally transferred. Through the fact that no light is emitted from an area in which the second subpixel 310-2 is disposed, it may be identified that the LED 420 in the area has not been transferred or has been detached.

The conductive jig 501 has rigidity to ensure flatness, but the conductive jig 501 may include a buffering material to prevent damage to the LED 420 when contacting the LED 420 for the lighting inspection. The conductive jig 501 having a thickness in a micrometer unit may undergo deflection due to a force applied to maintain contact with the LED 420 during the lighting inspection. When deflection occurs in the conductive jig 501 supported by the LED 420, the conductive jig 501 may contact the visually exposed conductive pad 403. When power is applied to the conductive jig 501 contacting the conductive pad 402, a short circuit may occur at the conductive pad 403 directly contacting the conductive jig 501. Due to occurrence of the short circuit, a display device 300 may be damaged.

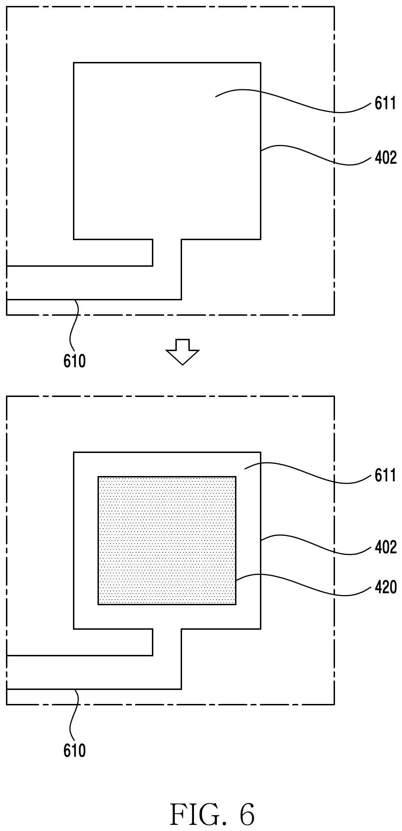

A structure and a method for preventing a short circuit occurring during the lighting inspection process will be described with reference to FIGS. 6 to 15 to be described later.

FIG. 6 is a drawing illustrating an exemplary process of mounting an LED element in an assembly process of an exemplary display device.

Referring to FIG. 6, a substrate (e.g., the substrate 401 of FIG. 4) including a conductive pad 402 may be prepared. The substrate 401 may include an insulating layer 611 applied on the conductive pad 402. The substrate 401 may further include, in addition to the conductive pad 402, an insulated wiring 610 connected to the conductive pad 402.

The insulating layer 611 and the insulated wiring 610 may include an oxide film. The insulating layer 611 may reduce oxidation of the conductive pad 402. The insulating layer 611 may include a thermoplastic material so that the insulating layer 611 may be removed under a pressurized or high-temperature state. During a bonding process of a first electrode (e.g., the first electrode 421 of FIG. 4) of an LED 420 and the conductive pad 402, the insulating layer 611 including the thermoplastic material may be removed at a contact surface with the first electrode 421. For example, during the bonding process, a portion of the insulating layer 611 corresponding to a surface of the first electrode 421 may be removed.

The insulating layer 611 may be disposed along a side surface of the first electrode 421 (or along an edge of the LED 420) disposed on the conductive pad 402. The insulating layer 611 may contact the side surface of the first electrode 421. Even after the bonding process, the insulating layer 611 may prevent the conductive pad 402 from being visually exposed to the outside. The insulating layer 611 may prevent oxidation of the conductive pad 402 before and after the bonding process.

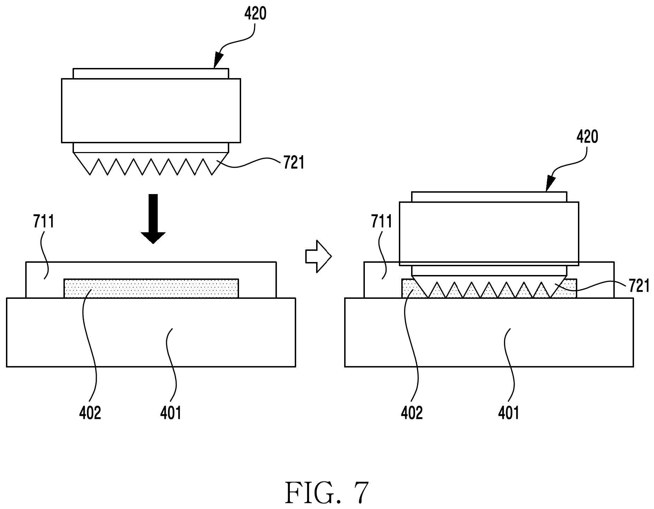

FIG. 7 is a drawing illustrating an exemplary process of mounting an LED element having an electrode of a concave-convex shape in an assembly process of an exemplary display device.

Referring to FIG. 7, an LED 420 may be disposed on a substrate including a conductive pad 402 surrounded by an insulating layer 711. The LED 420 may include a first electrode 721 (e.g., the first electrode 421 of FIG. 4) facing a substrate 401. The first electrode 721 may have a concave-convex shape. Protrusions of the concave-convex shape of the first electrode 721 may be formed in a sawtooth shape. The sawtooth-shaped protrusions of the first electrode 721 may penetrate the insulating layer 711. After passing through the insulating layer 711, the sawtooth-shaped protrusions of the first electrode 721 may penetrate a portion of the pad 402 or may contact the pad 402.

The LED 420 may be electrically connected to the conductive pad 402 through the first electrode 721 penetrating the insulating layer 711. The insulating layer 711 may include a through hole capable of accommodating at least a portion of the first electrode 721. For example, the insulating layer 711 may include a through hole for accommodating the protrusion of the first electrode 721.

The LED 420 of FIG. 6 and FIG. 7 may be electrically connected to the conductive pad 402 by removing at least a portion of the insulating layer 611 or 711 surrounding the conductive pad 402. A portion of the conductive pad 402 in which the LED 420 is not mounted may be surrounded by the insulating layer 611 or 711.

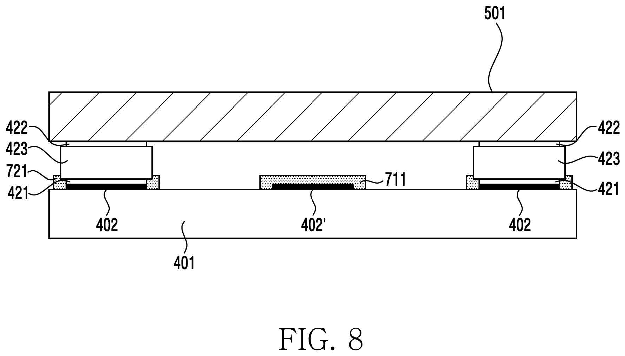

FIG. 8 is a drawing illustrating an exemplary process of performing a lighting inspection during an assembly process of an exemplary display device.

Referring to FIG. 8, for a lighting inspection of a display panel in which an LED 420 is disposed on a substrate 401, a conductive jig 501 may be disposed on the LED 420. The conductive jig 501 may be disposed to contact a second electrode 422 of the LED 420. The conductive jig 501 may contact the second electrode 422 of the LED 420 and apply voltage to a first electrode 421 and the second electrode 422. Based on the voltage applied to the first electrode 421 and the second electrode 422, a light emitting element 423 may emit light.

The LED 420 may be individually transferred onto the substrate 401, and the LED 420 may be bonded to a conductive pad 402. An LED 420 for which bonding is not completed may detach from a conductive pad 402' on the substrate 401. The deviated LED 420 may visually expose the conductive pad 402' to the outside.

The conductive jig 501 supported by the LED 420 having a micrometer unit may be formed of a thin conductive film, and when deflection occurs, the conductive jig 501 may contact the visually exposed conductive pad 402'. The visually exposed conductive pad 402' may be surrounded by an insulating layer 711. The conductive pad 402' surrounded by the insulating layer 711 may prevent direct contact with the conductive jig 501. The conductive pad 402' surrounded by the insulating layer 711 may reduce damage to a display device 300 caused by a short circuit between the conductive jig 501 and the conductive pad 402 during the lighting inspection.

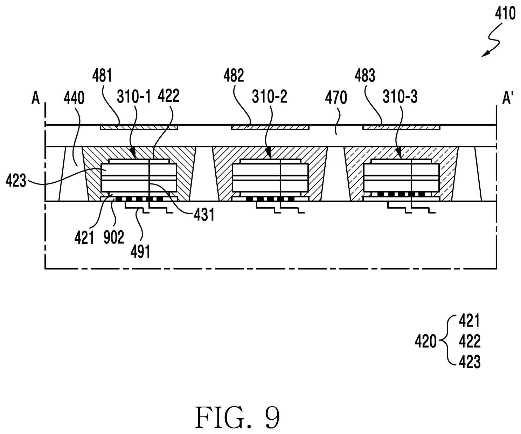

FIG. 9 is a drawing illustrating an exemplary display device including a patterned pad connected to a switching circuit.

Referring to FIG. 9, a display panel 410 may include a substrate 401, an LED 420, and/or an insulating member 440. The display panel 410 may be substantially the same as or similar to the display panel of FIG. 4 except for a conductive pad 902 exposed from the substrate 401 (or disposed on the substrate 401). A description of a configuration identical or similar to that of FIG. 4 is omitted. The term "substantially the same" may include not only cases in which the shape or size is identical, but also cases that include variations in ratio or partial modifications of the shape.

The substrate 401 may include a polymer or glass of a transparent or translucent material.

The substrate 401 may include switching circuits 491.

Subpixels 310-1 and 310-3 may be disposed on the substrate 401. Each of the subpixels 310-1 and 310-3 may include an LED 420. The LED 420 may include a first electrode 421, a second electrode 422, and a light emitting element 423.

The first electrode 421 may be bonded to the conductive pad 902 exposed from the substrate 401. The light emitting element 423 may be disposed on the first electrode 421. The second electrode 422 may be disposed on the light emitting element 423. The LED 420 may be referred to as a vertical LED or a vertical LED chip in terms of electrodes being vertically disposed.

The first electrode 421 may be connected to a first switching circuit 491 through bonding with the conductive pad 902.

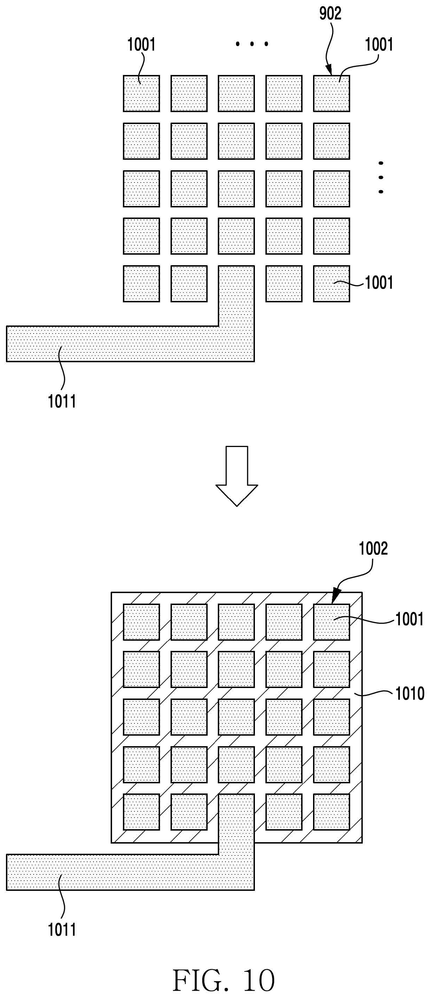

The conductive pad 902 may have a pattern different from the conductive pad 402 of FIG. 4. A shape of the pattern will be described in detail in FIGS. 10 to 11.

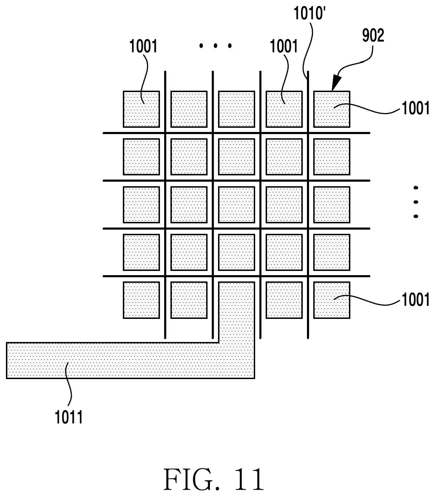

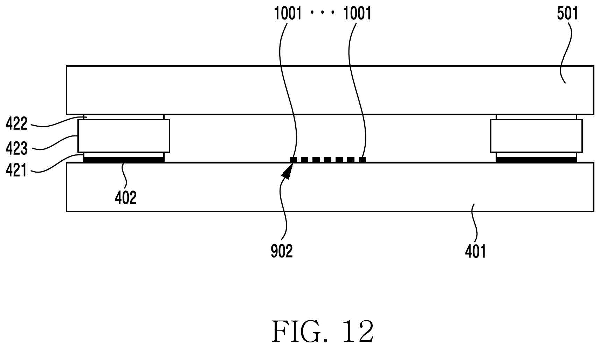

FIG. 10 is a drawing illustrating an exemplary process of welding an exemplary patterned pad. FIG. 11 illustrates an arrangement with a pattern protruding from a jig for a lighting inspection, which is inserted between exemplary patterned pads. FIG. 12 is a drawing illustrating an exemplary process of performing a lighting inspection during assembly of a display device including an exemplary patterned pad.

Referring to FIGS. 10, 11, and 12, a conductive pad 902 may include a plurality of pads 1001 separated along a grid pattern. The plurality of pads 1001 may be separated from each other. For example, the plurality of pads 1001 may be disposed spaced apart from each other. One of the plurality of pads 1001 that are spaced apart may be connected to a wiring 1011.

When a pad among the plurality of pads 1001 that is connected to the wiring 1011 does not contact a conductive jig (e.g., the conductive jig 501 of FIG. 5), a short circuit between the plurality of pads 1001 and the conductive jig may be reduced.

The plurality of separated pads 1001 of the conductive pads 902 may be disposed between the pads 1001 and formed into an integral pad by molten metal 1010 (e.g., solder). The metal 1010 may have a melting point lower than a melting point of the conductive pad 902. A conductive pad 1002 integrally formed by the molten metal 1010 may electrically connect an LED (e.g., the LED 420 of FIG. 4 or FIG. 9) and a switching circuit (e.g., the switching circuit 491 of FIG. 9).

Referring to FIG. 11, a conductive jig (e.g., the conductive jig 501 of FIG. 5) for a lighting inspection may include a mesh pattern 1010'. During the lighting inspection, the mesh pattern 1010' should be inserted into a space between the plurality of pads 1001 of a conductive pad 901 to be electrically connected to the conductive pad 901. The mesh pattern 1010' of the conductive jig 501 that is not inserted may be electrically separated from the conductive pad 901 and may be electrically connected only to a second electrode 422 of the LED 420. By reducing an electrical connection with the conductive pad 901 on which the LED 420 is not installed through the mesh pattern 1010', a short circuit between the conductive pad 901 and the conductive jig 501 may be reduced.

The segmented conductive pad 902 according to the above-described embodiment may reduce a probability of a short circuit caused by the conductive jig 501 by including the plurality of pads 1001. The conductive jig 501 may include a transparent material for the lighting inspection. To connect the LED 420 and a switching circuit (e.g., the switching circuit 491 of FIG. 4), a minimum voltage for lighting the LED 420 may be applied to electrodes 421 and 422 of the LED 420. When a contact area between the conductive jig 501 connected to the switching circuit and the conductive pad 902 is reduced, resistance may increase due to the reduced contact area. As resistance increases, current may not flow to the segmented conductive pad 902 on which the LED 420 is not installed, and may flow to the conductive pad 402 on which the LED 420 is installed. By preventing current from flowing to the segmented conductive pad 902 on which the LED 420 is not installed, a short circuit due to contact between the segmented conductive pad 902 and the conductive jig 501 due to deflection of the conductive jig 501 may be reduced.

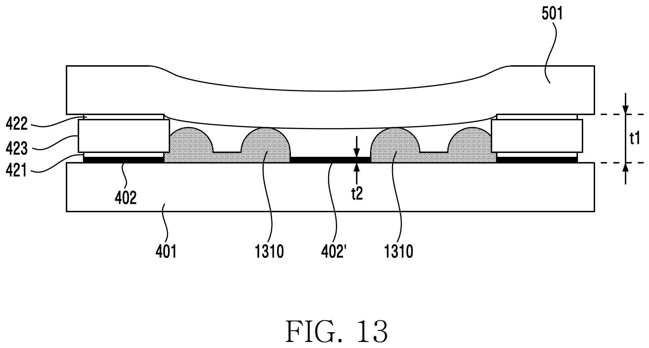

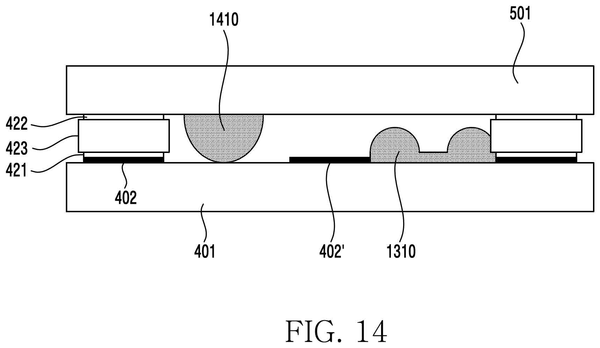

FIG. 13 is a drawing illustrating an exemplary process of performing a lighting inspection during assembly of a display device including a substrate having an exemplary insulating portion. FIG. 14 is a drawing illustrating an exemplary process of performing a lighting inspection during assembly of a display device using a jig having an exemplary insulating portion.

Referring to FIGS. 13 and 14, an insulating member 1310 or 1410 for preventing contact between a conductive jig 501 and a conductive pad 402' on which an LED 420 is not installed during a lighting inspection may be included.

The insulating member 1310 may be disposed between pixels. For example, the insulating member 1310 may be disposed between LEDs 420. The insulating member 1310 may include a polymer material including a non-conductive material. The polymer material may include a polymer foam.

The insulating member 1310 may reduce contact between the conductive pad 402' on which the LED 420 is not installed and the conductive jig 501 due to deflection of the conductive jig 501 installed on an upper portion of the LED 420 during the lighting inspection. The insulating member 1310 may be disposed on a substrate 401 and may have a thickness greater than a thickness t2 of the pad 402 or 402' and less than a sum of a thickness t1 of the LED 420 and the thickness t2 of the pad 402 or 402'. For example, a height of the insulating member 1310 may be lower than a height of the pad 402 or 402' and may be greater than a sum of heights of the LED 420 and the pad 402 or 402'. When the thickness of the insulating member 1310 is less than the thickness t2 of the pad 402 or 402', a short circuit may occur at the conductive pad 402' on which the LED 420 is not installed due to deflection of the conductive jig 501. To reduce occurrence of a short circuit, the insulating member 1310 may be formed thicker than the thickness of the pad.

The conductive jig 501 may include the insulating member 1410 disposed on a surface facing the substrate 401 of a display panel 410. The insulating member 1410 disposed on the conductive jig 501 may reduce deflection of the conductive jig 501. The insulating member 1410 may contact a surface of the substrate 401 and support the conductive jig 501. The insulating member 1410 supporting the conductive jig 501 may reduce a probability of contact between the conductive jig 501 and the conductive pad 402 or 402 by reducing deflection of the conductive jig 501.

According to the above-described embodiment, the insulating member 1310 installed on the substrate 401 may be physically removed, cleaned by a chemical method, or removed by reaction after completion of the lighting inspection.

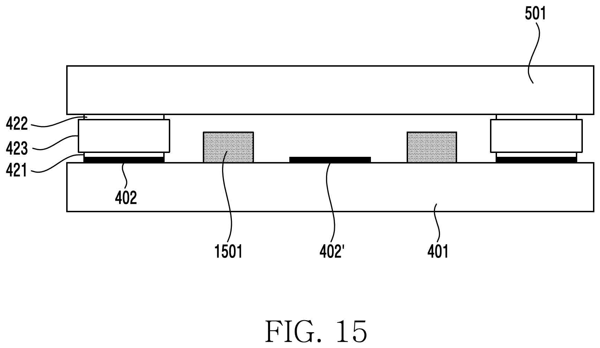

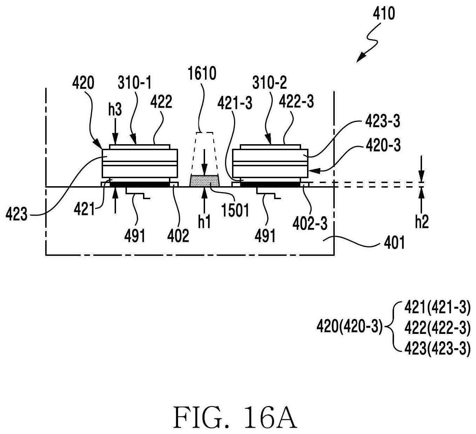

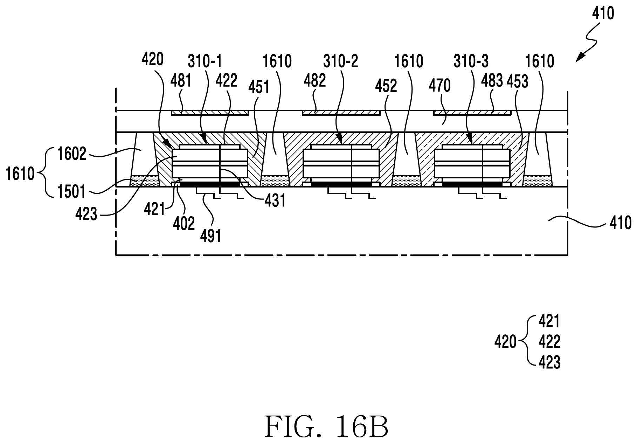

FIG. 15 is a drawing illustrating an assembly process of a display device using an exemplary insulating portion. FIG. 16A is a drawing illustrating an arrangement of an exemplary insulating portion of a display device. FIG. 16B is a drawing illustrating a state during assembly of a display device using an additional insulating portion disposed on an exemplary insulating portion.

Referring to FIG. 15, a display panel 410 may include an insulating member (e.g., the insulating member 1310 of FIG. 13) disposed between pixels (or LEDs 420), as in FIG. 13. Among the insulating member 1310, an insulating member 1501 may be first applied on a substrate 401. The insulating member 1501 may be thicker than a thickness of a conductive pad 402 or 402'.

During a lighting inspection, the insulating member 1501 may, by having a thickness thicker than the thickness of the pad 402 or 402', reduce occurrence of a short circuit at a conductive pad 402' on which an LED 420 is not installed due to deflection of a conductive jig 501.

Referring to FIG. 16A, a display panel 410 may include a substrate 401. The substrate 401 may be a base maintaining a shape of the display panel 410. The substrate 401 may be formed of a glass material or a polymer material. The display panel 410 may include a switching circuit 491. The switching circuit 491 may be formed on the substrate 401. The switching circuit 491 may selectively provide an electrical path for operation of each of pixels 310-1 and 310-2.

The display panel 410 may further include a first conductive pad 402 and a second conductive pad 402-3. The first conductive pad 402 and the second conductive pad 402-3 may be connected to the switching circuit 491. The first conductive pad 402 and the second conductive pad 402-3 may be disposed on the substrate 401 and configured to be connected to the switching circuit 491. The display panel 410 may further include a first LED 420 and a second LED 420-3. The first LED 420 may include a first electrode 421, a second electrode 422, and a light emitting element 423. The first electrode 421 may be connected to the first conductive pad 402. The light emitting element 423 may be disposed on the first electrode 421. The second electrode 422 may be disposed on the light emitting element 423. The substrate 401, the switching circuit 491, the first conductive pad 402, and the first LED 420 of FIG. 16A or 16B may be the same as or similar to the substrate 401, the switching circuit 491, the first conductive pad 402, and the LED 420 of FIG. 4. A description of a configuration similar to that of FIG. 4 is omitted.

The second LED 420-3 may include a third electrode 421-3, a fourth electrode 422-3, and a light emitting element 423-3. The third electrode 421-3 may be connected to the second conductive pad 402-3. The light emitting element 423-3 may be disposed on the third electrode 421-3. The fourth electrode 422-3 may be disposed on the light emitting element 423-3. A configuration of the second LED 420-3 may be substantially the same as a configuration of the first LED 420. The second LED 420-3 may be disposed adjacent to the first LED 420. Herein, "being disposed adjacent" may mean being disposed directly next to. For example, among a plurality of LEDs, the second LED 420-3 disposed adjacent to the first LED 420 may be disposed next to the first LED 420. Another LED may not be disposed between the first LED 420 and the second LED 420-3.

The display panel 410 may further include an insulating member 1501. The insulating member 1501 may be disposed between the first LED 420 and the second LED 420.

A height h1 of the insulating member 1501 may be higher than a height h2 of the first conductive pad 402, and the height h1 of the insulating member 1501 may be lower than a height h3 of the second LED 420-3 or the first LED 420 coupled to the first conductive pad 402. The height h1 of the insulating member 1501 may mean a distance from a surface of the insulating member 1501 contacting the substrate 401 to another surface of the insulating member 1501. The other surface of the insulating member 1501 may be a surface opposite to the surface of the insulating member 1501. The height h2 of the conductive pad 402 may mean a distance from a surface of the conductive pad 402 contacting the substrate 401 to another surface of the conductive pad 402. The other surface of the conductive pad 402 may be a surface opposite to the surface of the conductive pad 402. The height h3 of the second LED 420-3 or the first LED 420 coupled to the conductive pad 402 may mean a distance from the surface of the conductive pad 402 contacting the substrate 401 to another surface opposite to the surface of the second LED 420-3 or the first LED 420 contacting the conductive pad. The height h3 of the second LED 420-3 or the first LED 420 coupled to the conductive pad 402 may mean a distance from the substrate 401 to an upper surface (e.g., the other surface of the first LED 420 or the second LED 420-3) of the first LED 420 or the second LED 420-3. The height h3 of the second LED 420-3 or the first LED 420 coupled to the conductive pad 402 may mean a sum of a thickness of the conductive pad 402 and a thickness of the first LED 420 or the second LED 420-3. A thickness of the insulating member 1501, which is the height h1 of the insulating member 1501, may be greater than the thickness of the first conductive pad 402, and may be less than a sum of the thickness of the conductive pad 402 and the thickness of the first LED 420 or a sum of the thickness of the conductive pad 402 and the thickness of the second LED 420-3.

Referring to FIGS. 16A and 16B, the insulating member 1501 may be used as a portion of a dam 1610. The display panel 410 may include the dam 1610 surrounding each of subpixels 310-1 and 310-3. The dam 1610 may be a partition wall spaced apart from each of the subpixels 310-1 and 301-3 and extending to surround each of the subpixels 310-1 and 310-3. The dam 1610 may be disposed on the substrate 401 and may form a grid. The dam 1610 forming the grid may define a plurality of cells. A cell formed on the substrate 401 by the dam 1610 may be an area in which each of pixels 310-1, 301-2, 301-3, and 301-4 is disposed. An LED 420 may be mounted in each of cells distinguished by the dam 1610. A color conversion material may be filled in a cell in which the LED 420 is mounted.

The dam 1610 may be formed of an insulating material and may include a light-blocking material. The dam 1610 may be formed thicker than the LED 420. Since the thickness of the insulating member 1501 is formed greater than the conductive pad 402 and less than the LED 420, an additional insulating member 1602 may be added to compensate for the thickness of the dam 1610. A height of the dam 1610, that is, a sum of heights of the insulating member 1501 and the additional insulating member 1602, may be greater than a sum of the height of the first LED 420 coupled to the conductive pad 402 and the height of the conductive pad 402. When the conductive pad 402 is attached to the outside of the substrate 401, the height of the dam 1610 may be greater than the sum of the height of the conductive pad 402 and the height of the first LED 420.

The additional insulating member 1602 may be disposed on the insulating member 1501. The additional insulating member 1602 may be formed of substantially the same material as the insulating member 1501. However, it is not limited thereto and may include a material different from that of the insulating member 1501.

Color conversion materials 451 and 453 and a transparent material 452 may be disposed in a space surrounded by the insulating member 1501 and the additional insulating member 1602. The color conversion materials 451 and 453 may be the same as or similar to the color conversion materials 451 and 453 and the transparent material 452 of FIG. 4.

As the display panel 410 according to the above-described embodiment utilizes the insulating member 1501, which is for preventing a short circuit between the conductive pad 402 and a jig during a lighting inspection, as a portion of the dam 1610, the insulating member 1501 may be utilized as one of the components of the display panel 410 without being removed. The insulating member 1501 utilized as a component of the completed display panel 410 may reduce manufacturing cost of the display panel 410.

As described above, the configuration of the display device and the structure of the jig for a lighting inspection have been described in detail. Hereinafter, a method of manufacturing the display device will be described with reference to the drawings.

Referring to FIGS. 6 and 7, an LED 420 may be mounted on a conductive pad 402. By being mounted on the conductive pad 402, the LED 420 may be electrically connected to a switching circuit (e.g., the switching circuit 491 of FIG. 4). A first electrode 421 of the LED 420 may remove a portion of an insulating layer 611 surrounding the conductive pad 402 in order to be electrically connected to the conductive pad 402. The insulating layer 611 including a thermoplastic material may be removed under high temperature and high pressure when bonding the LED 420. The removed portion of the insulating layer 611 may correspond to the first electrode 421. For example, the removed portion of the insulating layer 611 may be substantially the same as an area of the first electrode 421. The insulating layer 611 may be disposed along a side surface of the first electrode 421 and may contact the side surface of the first electrode 421.

As illustrated in FIG. 6, a portion of the insulating layer 611 may be removed by a chemical method using high temperature and high pressure, but as illustrated in FIG. 7, a portion of an insulating layer 711 may be removed by a physical method.

While the LED 420 is connected to the conductive pad 402 on the substrate 401, the insulating layer 711 may remove a portion of the insulating layer 611 surrounding the conductive pad 402 by a sawtooth-shaped first electrode 721.

Through the first electrode 421 or 721 penetrating a portion of the insulating layer 611 or 711, the LED 420 may be electrically connected to the conductive pad 402. After the LED 420 is mounted, a lighting inspection may be performed using a conductive jig 501.

Referring to FIG. 8, the lighting inspection may be an inspection for confirming light emission of the LED 420 before connection of a second electrode 422. For the lighting inspection, the conductive jig 501 may be disposed to contact the second electrode 422 of the LED 420 mounted on the substrate 401. Even when deflection of the conductive jig 501 occurs, a short circuit may be prevented by the insulating layer 711 surrounding a pad 402' on which the LED 420 is not mounted.

Referring to FIG. 12, during the lighting inspection, even when the conductive jig 501 contacts some of a plurality of segmented pads 1001, it may contact a pad not connected to a wiring 1011, thereby preventing a short circuit. Even when the conductive jig 501 contacts a pad connected to the wiring 1011 among the plurality of segmented pads 1001, by increased resistance, flow of current to the wiring 1011 may be reduced, thereby preventing the conductive pad 402' and the conductive jig 501 from being short circuited.

Referring to FIGS. 13, 14, and 15, during the lighting inspection, the substrate 401 including a structure for preventing contact between the conductive jig 501 and the conductive pad 402' on which the LED 420 is not installed may be prepared. The structure may be utilized as a component configuring the display panel after completion of the lighting inspection. For example, after completion of the lighting inspection of the substrate 401 including an insulating member 1501, an additional insulating member 1602 may be disposed on the insulating member 1501 to form a dam 1610. The dam 1610 may form a cell surrounding an LED, and a color conversion material may be filled in the cell.

According to the above-described embodiment, since the display device includes a vertical LED structure, a conductive jig may be used to perform a lighting inspection of the LED after the LED is bonded to the substrate and before connection of an upper electrode (e.g., the second electrode 422 of FIG. 4). When using the conductive jig, a method for eliminating a short circuit between the conductive jig and a conductive pad disposed on the substrate is required.

The technical problems to be achieved in the present disclosure are not limited to those described above, and other technical problems not mentioned herein will be clearly understood by those having ordinary knowledge in the art to which the present disclosure belongs.

According to the above-described embodiment, a display panel (e.g., the display panel 410 of FIG. 4) may comprise a substrate 401, a switching circuit (e.g., the switching circuit 491 of FIG. 4) disposed on the substrate, and a first conductive pad 402 (e.g., the conductive pad 402 of FIG. 4) and a second conductive pad 402 (e.g., the conductive pad 402 of FIG. 4) connected to the switching circuit. The display panel 410 may comprise a first light emitting diode (LED) (e.g., the LED 420 of FIG. 4) including a first electrode 421 connected to the first conductive pad 402, a light emitting element 423 disposed on the first electrode 421, and a second electrode 422 disposed on the light emitting element 423, and a second LED 420 (e.g., the LED 420 of FIG. 4) including a third electrode connected to the second conductive pad 402', a light emitting element 423 disposed on the third electrode, and a fourth electrode disposed on the light emitting element 423.

The display panel 410 may comprise an insulating member (e.g., the insulating member 440 of FIG. 4 or the dam 1610 of FIG. 16A) disposed between the first LED 420 and the second LED 420.

A height of the insulating member 1501 may be greater than a height of the first conductive pad 402. The height of the insulating member 1501 may be lower than a height of the first LED coupled to the first conductive pad 402.

The insulating member 440, 1501, or 1610 may be thicker than a thickness of the first conductive pad 402.

According to an embodiment, the display panel may comprise an additional insulating member 1602 disposed on the insulating member 1501.

According to an embodiment, a sum of the height of the insulating member and a height of the additional insulating member may be greater than the height of the first LED 420 coupled to the first conductive pad.

According to an embodiment, the insulating member and the additional insulating member may surround the first LED 420 along a side surface of the first LED 420.

According to an embodiment, the display panel may further comprise a color conversion material (e.g., the color conversion materials 451, 452, and 453 of FIG. 4) disposed in a space surrounded by the insulating member 440 or 1610.

According to an embodiment, a color of light emitted from the first LED 420 and the second LED 420 may be the same.

According to an embodiment, the insulating member 440 or 1610 may have a concave-convex shape and may be spaced apart from the first LED 420 and the second LED 420.

According to an embodiment, the first LED may be disposed adjacent to the second LED.

According to an embodiment, the second electrode and the fourth electrode may include a transparent material configured to transmit light emitted from the light emitting element of the first LED and the light emitting element of the second LED, respectively.

According to an embodiment, the display panel may further comprise an additional transparent substrate disposed on the second electrode and the fourth electrode and configured to connect each of the second electrode and the fourth electrode to a switching circuit.

According to an embodiment, a display panel 410 may comprise a substrate 401, a switching circuit 491 formed on the substrate, a conductive pad connected to the switching circuit 491 and formed on the substrate, and an LED 420 including a first electrode 421 connected to the conductive pad 402, a light emitting element 423 disposed on the first electrode 421, and a second electrode 422 disposed on the light emitting element 423, wherein the conductive pad 402 may include partial pads spaced apart from each other, and the conductive pad 402 may be coupled to the first electrode by a conductive material disposed between the partial pads.

According to an embodiment, the display panel 410 may comprise a non-conductive layer covering a side surface of the first conductive pad 402 and a portion of an upper surface of the first conductive pad 402.

According to an embodiment, a surface of the first electrode 421 may contact a surface of the first conductive pad 402.

According to an embodiment, the non-conductive layer may contact a side surface of the first electrode 421 along an edge of an area corresponding to the surface of the first electrode 421, on the first conductive pad 402.

According to an embodiment, an area of the upper surface of the first conductive pad 402 exposed through the non-conductive layer may be equal to an area of the first electrode 421.

According to an embodiment, the first conductive pad 402 may include partial pads spaced apart from each other and a conductive material disposed between the partial pads.

According to an embodiment, a melting point of the conductive material may be lower than a melting point of the first conductive pad 402.

According to an embodiment, the first electrode 421 may include a protrusion facing the first conductive pad 402.

According to an embodiment, it may further comprise a non-conductive layer disposed on the first conductive pad 402.

According to an embodiment, the non-conductive layer may include a hole into which the protrusion is inserted.

According to an embodiment, the display panel may comprise a third conductive pad disposed on the substrate and a non-conductive layer surrounding the third conductive pad.

A display panel 410 may comprise a substrate, a switching circuit disposed on the substrate, and a conductive pad connected to the switching circuit. The display panel 410 may comprise an LED 420 including a first electrode 421 connected to the conductive pad and including a protrusion facing the conductive pad, a light emitting element 423 disposed on the first electrode 421, and a second electrode 422 disposed on the light emitting element 423. The display panel 410 may further comprise a non-conductive layer covering a portion of an upper surface of the first conductive pad 402.

According to an embodiment, a surface of the first electrode may contact a surface of the first conductive pad, and the non-conductive layer may be disposed along a side surface of the first electrode on the first conductive pad.

According to an embodiment, an area of the upper surface of the first conductive pad exposed through the non-conductive layer may be equal to an area of the first electrode contacting the upper surface of the first conductive pad.

According to an embodiment, the insulating member 1501 may be thicker than a thickness of the conductive pad.

According to an embodiment, the insulating member 440 or 1610 may be thicker than the LED 420.

According to an embodiment, the insulating member 440 or 1610 may surround the LED 420 along a side surface of the LED 420.

According to an embodiment, the display panel 410 may further comprise a color conversion material disposed in a space surrounded by the insulating member 440 or 1610.

According to an embodiment, the first electrode may include a protrusion protruding toward the conductive pad and contacting the conductive pad, and the non-conductive layer may include a hole into which the protrusion is inserted.

According to an embodiment, the conductive pad may include a groove configured to accommodate the protrusion and continuous with the hole.

FIG. 17 is a block diagram illustrating an electronic device 1701 in a network environment 1700 according to various embodiments.

Referring to FIG. 17, the electronic device 1701 in the network environment 1700 may communicate with an electronic device 1702 via a first network 1798 (e.g., a short-range wireless communication network), or at least one of an electronic device 1704 or a server 1708 via a second network 1799 (e.g., a long-range wireless communication network). According to an embodiment, the electronic device 1701 may communicate with the electronic device 1704 via the server 1708. According to an embodiment, the electronic device 1701 may include a processor 1720, memory 1730, an input module 1750, a sound output module 1755, a display module 1760, an audio module 1770, a sensor module 1776, an interface 1777, a connecting terminal 1778, a haptic module 1779, a camera module 1780, a power management module 1788, a battery 1789, a communication module 1790, a subscriber identification module(SIM) 1796, or an antenna module 1797. In some embodiments, at least one of the components (e.g., the connecting terminal 1778) may be omitted from the electronic device 1701, or one or more other components may be added in the electronic device 1701. In some embodiments, some of the components (e.g., the sensor module 1776, the camera module 1780, or the antenna module 1797) may be implemented as a single component (e.g., the display module 1760).

The processor 1720 may execute, for example, software (e.g., a program 1740) to control at least one other component (e.g., a hardware or software component) of the electronic device 1701 coupled with the processor 1720, and may perform various data processing or computation. According to an embodiment, as at least part of the data processing or computation, the processor 1720 may store a command or data received from another component (e.g., the sensor module 1776 or the communication module 1790) in volatile memory 1732, process the command or the data stored in the volatile memory 1732, and store resulting data in non-volatile memory 1734. According to an embodiment, the processor 1720 may include a main processor 1721 (e.g., a central processing unit (CPU) or an application processor (AP)), or an auxiliary processor 1723 (e.g., a graphics processing unit (GPU), a neural processing unit (NPU), an image signal processor (ISP), a sensor hub processor, or a communication processor (CP)) that is operable independently from, or in conjunction with, the main processor 1721. For example, when the electronic device 1701 includes the main processor 1721 and the auxiliary processor 1723, the auxiliary processor 1723 may be adapted to consume less power than the main processor 1721, or to be specific to a specified function. The auxiliary processor 1723 may be implemented as separate from, or as part of the main processor 1721.

The auxiliary processor 1723 may control at least some of functions or states related to at least one component (e.g., the display module 1760, the sensor module 1776, or the communication module 1790) among the components of the electronic device 1701, instead of the main processor 1721 while the main processor 1721 is in an inactive (e.g., sleep) state, or together with the main processor 1721 while the main processor 1721 is in an active state (e.g., executing an application). According to an embodiment, the auxiliary processor 1723 (e.g., an image signal processor or a communication processor) may be implemented as part of another component (e.g., the camera module 1780 or the communication module 1790) functionally related to the auxiliary processor 1723. According to an embodiment, the auxiliary processor 1723 (e.g., the neural processing unit) may include a hardware structure specified for artificial intelligence model processing. An artificial intelligence model may be generated by machine learning. Such learning may be performed, e.g., by the electronic device 1701 where the artificial intelligence is performed or via a separate server (e.g., the server 1708). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 1730 may store various data used by at least one component (e.g., the processor 1720 or the sensor module 1776) of the electronic device 1701. The various data may include, for example, software (e.g., the program 1740) and input data or output data for a command related thereto. The memory 1730 may include the volatile memory 1732 or the non-volatile memory 1734.

The program 1740 may be stored in the memory 1730 as software, and may include, for example, an operating system (OS) 1742, middleware 1744, or an application 1746.

The input module 1750 may receive a command or data to be used by another component (e.g., the processor 1720) of the electronic device 1701, from the outside (e.g., a user) of the electronic device 1701. The input module 1750 may include, for example, a microphone, a mouse, a keyboard, a key (e.g., a button), or a digital pen (e.g., a stylus pen).

The sound output module 1755 may output sound signals to the outside of the electronic device 1701. The sound output module 1755 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 1760 may visually provide information to the outside (e.g., a user) of the electronic device 1701. The display module 1760 may include, for example, a display, a hologram device, or a projector and control circuitry to control a corresponding one of the display, hologram device, and projector. According to an embodiment, the display module 1760 may include a touch sensor adapted to detect a touch, or a pressure sensor adapted to measure the intensity of force incurred by the touch.

The audio module 1770 may convert a sound into an electrical signal and vice versa. According to an embodiment, the audio module 1770 may obtain the sound via the input module 1750, or output the sound via the sound output module 1755 or a headphone of an external electronic device (e.g., an electronic device 1702) directly (e.g., wiredly) or wirelessly coupled with the electronic device 1701.

The sensor module 1776 may detect an operational state (e.g., power or temperature) of the electronic device 1701 or an environmental state (e.g., a state of a user) external to the electronic device 1701, and then generate an electrical signal or data value corresponding to the detected state. According to an embodiment, the sensor module 1776 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 1777 may support one or more specified protocols to be used for the electronic device 1701 to be coupled with the external electronic device (e.g., the electronic device 1702) directly (e.g., wiredly) or wirelessly. According to an embodiment, the interface 1777 may include, for example, a high definition multimedia interface (HDMI), a universal serial bus (USB) interface, a secure digital (SD) card interface, or an audio interface.

A connecting terminal 1778 may include a connector via which the electronic device 1701 may be physically connected with the external electronic device (e.g., the electronic device 1702). According to an embodiment, the connecting terminal 1778 may include, for example, an HDMI connector, a USB connector, an SD card connector, or an audio connector (e.g., a headphone connector).

The haptic module 1779 may convert an electrical signal into a mechanical stimulus (e.g., a vibration or a movement) or electrical stimulus which may be recognized by a user via his tactile sensation or kinesthetic sensation. According to an embodiment, the haptic module 1779 may include, for example, a motor, a piezoelectric element, or an electric stimulator.

The camera module 1780 may capture a still image or moving images. According to an embodiment, the camera module 1780 may include one or more lenses, image sensors, image signal processors, or flashes.

The power management module 1788 may manage power supplied to the electronic device 1701. According to an embodiment, the power management module 1788 may be implemented as at least part of, for example, a power management integrated circuit (PMIC).

The battery 1789 may supply power to at least one component of the electronic device 1701. According to an embodiment, the battery 1789 may include, for example, a primary cell which is not rechargeable, a secondary cell which is rechargeable, or a fuel cell.

The communication module 1790 may support establishing a direct (e.g., wired) communication channel or a wireless communication channel between the electronic device 1701 and the external electronic device (e.g., the electronic device 1702, the electronic device 1704, or the server 1708) and performing communication via the established communication channel. The communication module 1790 may include one or more communication processors that are operable independently from the processor 1720 (e.g., the application processor (AP)) and supports a direct (e.g., wired) communication or a wireless communication. According to an embodiment, the communication module 1790 may include a wireless communication module 1792 (e.g., a cellular communication module, a short-range wireless communication module, or a global navigation satellite system (GNSS) communication module) or a wired communication module 1794 (e.g., a local area network (LAN) communication module or a power line communication (PLC) module). A corresponding one of these communication modules may communicate with the external electronic device via the first network 1798 (e.g., a short-range communication network, such as Bluetooth^{™}, wireless-fidelity (Wi-Fi) direct, or infrared data association (IrDA)) or the second network 1799 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 1792 may identify and authenticate the electronic device 1701 in a communication network, such as the first network 1798 or the second network 1799, using subscriber information (e.g., international mobile subscriber identity (IMSI)) stored in the subscriber identification module 1796.

The wireless communication module 1792 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 1792 may support a high-frequency band (e.g., the mmWave band) to achieve, e.g., a high data transmission rate. The wireless communication module 1792 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 1792 may support various requirements specified in the electronic device 1701, an external electronic device (e.g., the electronic device 1704), or a network system (e.g., the second network 1799). According to an embodiment, the wireless communication module 1792 may support a peak data rate (e.g., 20Gbps or more) for implementing eMBB, loss coverage (e.g., 1764dB or less) for implementing mMTC, or U-plane latency (e.g., 0.5ms or less for each of downlink (DL) and uplink (UL), or a round trip of 17ms or less) for implementing URLLC.

The antenna module 1797 may transmit or receive a signal or power to or from the outside (e.g., the external electronic device) of the electronic device 1701. According to an embodiment, the antenna module 1797 may include an antenna including a radiating element composed of a conductive material or a conductive pattern formed in or on a substrate (e.g., a printed circuit board (PCB)). According to an embodiment, the antenna module 1797 may include a plurality of antennas (e.g., array antennas). In such a case, at least one antenna appropriate for a communication scheme used in the communication network, such as the first network 1798 or the second network 1799, may be selected, for example, by the communication module 1790 (e.g., the wireless communication module 1792) from the plurality of antennas. The signal or the power may then be transmitted or received between the communication module 1790 and the external electronic device via the selected at least one antenna. According to an embodiment, another component (e.g., a radio frequency integrated circuit (RFIC)) other than the radiating element may be additionally formed as part of the antenna module 1797.

According to various embodiments, the antenna module 1797 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 1701 and the external electronic device 1704 via the server 1708 coupled with the second network 1799. Each of the electronic devices 1702 or 1704 may be a device of a same type as, or a different type, from the electronic device 1701. According to an embodiment, all or some of operations to be executed at the electronic device 1701 may be executed at one or more of the external electronic devices 1702, 1704, or 1708. For example, if the electronic device 1701 should perform a function or a service automatically, or in response to a request from a user or another device, the electronic device 1701, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 1701. The electronic device 1701 may provide the outcome, with or without further processing of the outcome, as at least part of a reply to the request. To that end, a cloud computing, distributed computing, mobile edge computing (MEC), or client-server computing technology may be used, for example. The electronic device 1701 may provide ultra low-latency services using, e.g., distributed computing or mobile edge computing. In another embodiment, the external electronic device 1704 may include an internet-of-things (IoT) device. The server 1708 may be an intelligent server using machine learning and/or a neural network. According to an embodiment, the external electronic device 1704 or the server 1708 may be included in the second network 1799. The electronic device 1701 may be applied to intelligent services (e.g., smart home, smart city, smart car, or healthcare) based on 5G communication technology or IoT-related technology.

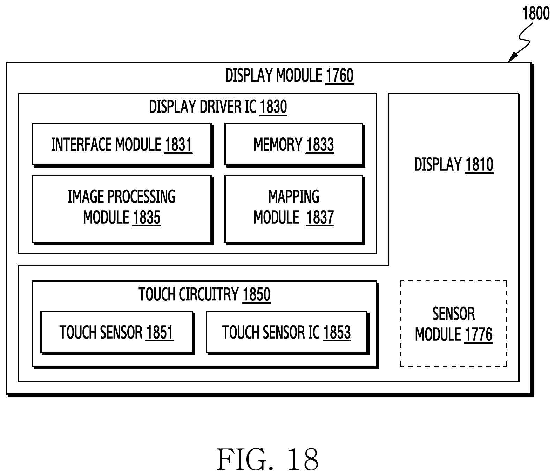

FIG. 18 is a block diagram 1800 illustrating the display module 1760 according to various embodiments.

Referring to FIG. 18, the display module 1760 may include a display 1810 and a display driver integrated circuit (DDI) 1830 to control the display 1810. The DDI 1830 may include an interface module 1831, memory 1833 (e.g., buffer memory), an image processing module 1835, or a mapping module 1837. The DDI 1830 may receive image information that contains image data or an image control signal corresponding to a command to control the image data from another component of the electronic device 1701 via the interface module 1831. For example, according to an embodiment, the image information may be received from the processor 1720 (e.g., the main processor 1721 (e.g., an application processor)) or the auxiliary processor 1723 (e.g., a graphics processing unit) operated independently from the function of the main processor 1721. The DDI 1830 may communicate, for example, with touch circuitry 1850 or the sensor module 1776 via the interface module 1831. The DDI 1830 may also store at least part of the received image information in the memory 1833, for example, on a frame by frame basis. The image processing module 1835 may perform pre-processing or post-processing (e.g., adjustment of resolution, brightness, or size) with respect to at least part of the image data. According to an embodiment, the pre-processing or post-processing may be performed, for example, based at least in part on one or more characteristics of the image data or one or more characteristics of the display 1810. The mapping module 1837 may generate a voltage value or a current value corresponding to the image data pre-processed or post-processed by the image processing module 1835. According to an embodiment, the generating of the voltage value or current value may be performed, for example, based at least in part on one or more attributes of the pixels (e.g., an array, such as an RGB stripe or a pentile structure, of the pixels, or the size of each subpixel). At least some pixels of the display 1810 may be driven, for example, based at least in part on the voltage value or the current value such that visual information (e.g., a text, an image, or an icon) corresponding to the image data may be displayed via the display 1810.

According to an embodiment, the display module 1760 may further include the touch circuitry 1850. The touch circuitry 1850 may include a touch sensor 1851 and a touch sensor IC 1853 to control the touch sensor 1851. The touch sensor IC 1853 may control the touch sensor 1851 to sense a touch input or a hovering input with respect to a certain position on the display 1810. To achieve this, for example, the touch sensor 1851 may detect (e.g., measure) a change in a signal (e.g., a voltage, a quantity of light, a resistance, or a quantity of one or more electric charges) corresponding to the certain position on the display 1810. The touch circuitry 1850 may provide input information (e.g., a position, an area, a pressure, or a time) indicative of the touch input or the hovering input detected via the touch sensor 1851 to the processor 1720. According to an embodiment, at least part (e.g., the touch sensor IC 1853) of the touch circuitry 1850 may be formed as part of the display 1810 or the DDI 1830, or as part of another component (e.g., the auxiliary processor 1723) disposed outside the display module 1760.

According to an embodiment, the display module 1760 may further include at least one sensor (e.g., a fingerprint sensor, an iris sensor, a pressure sensor, or an illuminance sensor) of the sensor module 1776 or a control circuit for the at least one sensor. In such a case, the at least one sensor or the control circuit for the at least one sensor may be embedded in one portion of a component (e.g., the display 1810, the DDI 1830, or the touch circuitry 1850)) of the display module 1760. For example, when the sensor module 1776 embedded in the display module 1760 includes a biometric sensor (e.g., a fingerprint sensor), the biometric sensor may obtain biometric information (e.g., a fingerprint image) corresponding to a touch input received via a portion of the display 1810. As another example, when the sensor module 1776 embedded in the display module 1760 includes a pressure sensor, the pressure sensor may obtain pressure information corresponding to a touch input received via a partial or whole area of the display 1810. According to an embodiment, the touch sensor 1851 or the sensor module 1776 may be disposed between pixels in a pixel layer of the display 1810, or over or under the pixel layer.

Referring to FIGS. 19A and 19B, according to an embodiment, a wearable device 1900 may have a form of glasses that is wearable on a body part (e.g., head) of a user. The wearable device 1900 may include a head-mounted display (HMD). For example, a housing of the wearable device 1900 may include a flexible material such as rubber and/or silicone having a form closely attached to a portion of the user's head (for example, a portion of a face surrounding two eyes). For example, the housing of the wearable device 1900 may include one or more straps able to be twined around the user's head, and/or one or more temples attachable to ears of the head.

Referring to FIG. 19A, according to an embodiment, the wearable device 1900 may include at least one display 1950 and a frame supporting the at least one display 1950.

According to an embodiment, the wearable device 1900 may be wearable on a portion of the user's body. The wearable device 1900 may provide augmented reality (AR), virtual reality (VR), or mixed reality (MR) combining the augmented reality and the virtual reality to a user wearing the wearable device 1900. For example, the wearable device 1900 may display a virtual reality image provided from at least one optical device 1982 and 1984 of FIG. 19B on at least one display 1950, in response to a user's preset gesture obtained through a motion recognition camera 1960-2 and 1960-3 of FIG. 19B.

According to an embodiment, the at least one display 1950 may provide visual information to a user. For example, the at least one display 1950 may include a transparent or translucent lens. The at least one display 1950 may include a first display 1950-1 and/or a second display 1950-2 spaced apart from the first display 1950-1. For example, the first display 1950-1 and the second display 1950-2 may be disposed at positions corresponding to the user's left and right eyes, respectively.

Referring to FIG. 19B, the at least one display 1950 may provide visual information transmitted through a lens included in the at least one display 1950 from ambient light to a user and other visual information distinguished from the visual information19. The lens may be formed based on at least one of a fresnel lens, a pancake lens, or a multi-channel lens. For example, the at least one display 1950 may include a first surface 1931 and a second surface 1932 opposite to the first surface 1931. A display area may be formed on the second surface 1932 of at least one display 1950. When the user wears the wearable device 1900, ambient light may be transmitted to the user by being incident on the first surface 1931 and being penetrated through the second surface 1932. For another example, the at least one display 1950 may display an augmented reality image in which a virtual reality image provided by the at least one optical device 1982 and 1984 is combined with a reality screen transmitted through ambient light, on a display area formed on the second surface 1932.

According to an embodiment, the at least one display 1950 may include at least one waveguide 1933 and 1934 that transmits light transmitted from the at least one optical device 1982 and 1984 by diffracting to the user. The at least one waveguide 1933 and 1934 may be formed based on at least one of glass, plastic, or polymer. A nano pattern may be formed on at least a portion of the outside or inside of the at least one waveguide 1933 and 1934. The nano pattern may be formed based on a grating structure having a polygonal or curved shape. Light incident to an end of the at least one waveguide 1933 and 1934 may be propagated to another end of the at least one waveguide 1933 and 1934 by the nano pattern. The at least one waveguide 1933 and 1934 may include at least one of at least one diffraction element (e.g., a diffractive optical element (DOE), a holographic optical element (HOE)), and a reflection element (e.g., a reflection mirror). For example, the at least one waveguide 1933 and 1934 may be disposed in the wearable device 1900 to guide a screen displayed by the at least one display 1950 to the user's eyes. For example, the screen may be transmitted to the user's eyes based on total internal reflection (TIR) generated in the at least one waveguide 1933 and 1934.

The wearable device 1900 may analyze an object included in a real image collected through a photographing camera 1960-4, combine with a virtual object corresponding to an object that becomes a subject of augmented reality provision among the analyzed object, and display on the at least one display 1950. The virtual object may include at least one of text and images for various information associated with the object included in the real image. The wearable device 1900 may analyze the object based on a multi-camera such as a stereo camera. For the object analysis, the wearable device 1900 may execute space recognition (e.g., simultaneous localization and mapping (SLAM)) using the multi-camera and/or time-of-flight (ToF). The user wearing the wearable device 1900 may watch an image displayed on the at least one display 1950.

According to an embodiment, a frame may be configured with a physical structure in which the wearable device 1900 may be worn on the user's body. According to an embodiment, the frame may be configured so that when the user wears the wearable device 1900, the first display 1950-1 and the second display 1950-2 may be positioned corresponding to the user's left and right eyes. The frame may support the at least one display 1950. For example, the frame may support the first display 1950-1 and the second display 1950-2 to be positioned at positions corresponding to the user's left and right eyes.

Referring to FIG. 19A, according to an embodiment, the frame may include an area 1920 at least partially in contact with the portion of the user's body in case that the user wears the wearable device 1900. For example, the area 1920 of the frame in contact with the portion of the user's body may include an area in contact with a portion of the user's nose, a portion of the user's ear, and a portion of the side of the user's face that the wearable device 1900 contacts. According to an embodiment, the frame may include a nose pad 1910 that is contacted on the portion of the user's body. When the wearable device 1900 is worn by the user, the nose pad 1910 may be contacted on the portion of the user's nose. The frame may include a first temple 1904 and a second temple 1905, which are contacted on another portion of the user's body that is distinct from the portion of the user's body.

For example, the frame may include a first rim 1901 surrounding at least a portion of the first display 1950-1, a second rim 1902 surrounding at least a portion of the second display 1950-2, a bridge 1903 disposed between the first rim 1901 and the second rim 1902, a first pad 1911 disposed along a portion of the edge of the first rim 1901 from one end of the bridge 1903, a second pad 1912 disposed along a portion of the edge of the second rim 1902 from the other end of the bridge 1903, the first temple 1904 extending from the first rim 1901 and fixed to a portion of the wearer's ear, and the second temple 1905 extending from the second rim 1902 and fixed to a portion of the ear opposite to the ear. The first pad 1911 and the second pad 1912 may be in contact with the portion of the user's nose, and the first temple 1904 and the second temple 1905 may be in contact with a portion of the user's face and the portion of the user's ear. The temples 1904 and 1905 may be rotatably connected to the rim through hinge units 1906 and 1907 of FIG. 19B. The first temple 1904 may be rotatably connected with respect to the first rim 1901 through the first hinge unit 1906 disposed between the first rim 1901 and the first temple 1904. The second temple 1905 may be rotatably connected with respect to the second rim 1902 through the second hinge unit 1907 disposed between the second rim 1902 and the second temple 1905. According to an embodiment, the wearable device 1900 may identify an external object (e.g., a user's fingertip) touching the frame and/or a gesture performed by the external object by using a touch sensor, a grip sensor, and/or a proximity sensor formed on at least a portion of the surface of the frame.

According to an embodiment, the wearable device 1900 may include hardware (e.g., hardware described above based on the block diagram of FIG. 17) that performs various functions. For example, the hardware may include a battery module 1970, an antenna module 1975, the at least one optical device 1982 and 1984, speakers (e.g., speakers 1955-1 and 1955-2), a microphone (e.g., microphones 1965-1, 1965-2, and 1965-3), a light emitting module, and/or a printed circuit board (PCB) 1990 (e.g., printed circuit board). Various hardware components may be disposed in the frame.

According to an embodiment, the microphone (e.g., the microphones 1965-1, 1965-2, and 1965-3) of the wearable device 1900 may obtain a sound signal, by being disposed on at least a portion of the frame. The first microphone 1965-1 disposed on the bridge 1903, the second microphone 1965-2 disposed on the second rim 1902, and the third microphone 1965-3 disposed on the first rim 1901 are illustrated in FIG. 19B, but the number and disposition of the microphone 1965 are not limited to an embodiment of FIG. 19B. In case that the number of the microphone 1965 included in the wearable device 1900 is two or more, the wearable device 1900 may identify a direction of the sound signal by using a plurality of microphones disposed on different portions of the frame.

According to an embodiment, the at least one optical device 1982 and 1984 may project a virtual object on the at least one display 1950 in order to provide various image information to the user. For example, the at least one optical device 1982 and 1984 may be a projector. The at least one optical device 1982 and 1984 may be disposed adjacent to the at least one display 1950 or may be included in the at least one display 1950 as a portion of the at least one display 1950. According to an embodiment, the wearable device 1900 may include a first optical device 1982 corresponding to the first display 1950-1, and a second optical device 1984 corresponding to the second display 1950-2. For example, the at least one optical device 1982 and 1984 may include the first optical device 1982 disposed at a periphery of the first display 1950-1 and the second optical device 1984 disposed at a periphery of the second display 1950-2. The first optical device 1982 may transmit light to the first waveguide 1933 disposed on the first display 1950-1, and the second optical device 1984 may transmit light to the second waveguide 1934 disposed on the second display 1950-2.

In an embodiment, a camera 1960 may include the photographing camera 1960-4, an eye tracking camera (ET CAM) 1960-1, and/or the motion recognition camera 1960-2 and 1960-3. The photographing camera 1960-4, the eye tracking camera 1960-1, and the motion recognition camera 1960-2 and 1960-3 may be disposed at different positions on the frame and may perform different functions. The eye tracking camera 1960-1 may output data indicating a position of eye or a gaze of the user wearing the wearable device 1900. For example, the wearable device 1900 may detect the gaze from an image including the user's pupil obtained through the eye tracking camera 1960-1.

The wearable device 1900 may identify an object (e.g., a real object, and/or a virtual object) focused by the user, by using the user's gaze obtained through the eye tracking camera 1960-1. The wearable device 1900 identifying the focused object may execute a function (e.g., gaze interaction) for interaction between the user and the focused object. The wearable device 1900 may represent a portion corresponding to eye of an avatar indicating the user in the virtual space, by using the user's gaze obtained through the eye tracking camera 1960-1. The wearable device 1900 may render an image (or a screen) displayed on the at least one display 1950, based on the position of the user's eye.

For example, visual quality (e.g., resolution, brightness, saturation, grayscale, and PPI) of a first area related to the gaze within the image and visual quality of a second area distinguished from the first area may be different. The wearable device 1900 may obtain an image having the visual quality of the first area matching the user's gaze and the visual quality of the second area by using foveated rendering. For example, when the wearable device 1900 supports an iris recognition function, user authentication may be performed based on iris information obtained using the eye tracking camera 1960-1. An example in which the eye tracking camera 1960-1 is disposed toward the user's right eye is illustrated in FIG. 19B, but the embodiment is not limited thereto, and the eye tracking camera 1960-1 may be disposed alone toward the user's left eye or may be disposed toward two eyes.

In an embodiment, the photographing camera 1960-4 may photograph a real image or background to be matched with a virtual image in order to implement the augmented reality or mixed reality content. The photographing camera 1960-4 may be used to obtain an image having a high resolution based on a high resolution (HR) or a photo video (PV). The photographing camera 1960-4 may photograph an image of a specific object existing at a position viewed by the user and may provide the image to the at least one display 1950. The at least one display 1950 may display one image in which a virtual image provided through the at least one optical device 1982 and 1984 is overlapped with information on the real image or background including an image of the specific object obtained by using the photographing camera 1960-4. The wearable device 1900 may compensate for depth information (e.g., a distance between the wearable device 1900 and an external object obtained through a depth sensor), by using an image obtained through the photographing camera 1960-4. The wearable device 1900 may perform object recognition through an image obtained using the photographing camera 1960-4. The wearable device 1900 may perform a function (e.g., auto focus) of focusing an object (or subject) within an image and/or an optical image stabilization (OIS) function (e.g., an anti-shaking function) by using the photographing camera 1960-4. While displaying a screen representing a virtual space on the at least one display 1950, the wearable device 1900 may perform a pass through function for displaying an image obtained through the photographing camera 1960-4 overlapping at least a portion of the screen. In an embodiment, the photographing camera 1960-4 may be disposed on the bridge 1903 disposed between the first rim 1901 and the second rim 1902.

The eye tracking camera 1960-1 may implement a more realistic augmented reality by matching the user's gaze with the visual information provided on the at least one display 1950, by tracking the gaze of the user wearing the wearable device 1900. For example, when the user looks at the front, the wearable device 1900 may naturally display environment information associated with the user's front on the at least one display 1950 at a position where the user is positioned. The eye tracking camera 1960-1 may be configured to capture an image of the user's pupil in order to determine the user's gaze. For example, the eye tracking camera 1960-1 may receive gaze detection light reflected from the user's pupil and may track the user's gaze based on the position and movement of the received gaze detection light. In an embodiment, the eye tracking camera 1960-1 may be disposed at a position corresponding to the user's left and right eyes. For example, the eye tracking camera 1960-1 may be disposed in the first rim 1901 and/or the second rim 1902 to face the direction in which the user wearing the wearable device 1900 is positioned.

The motion recognition camera 1960-2 and 1960-3 may provide a specific event to the screen provided on the at least one display 1950 by recognizing the movement of the whole or portion of the user's body, such as the user's torso, hand, or face. The motion recognition camera 1960-2 and 1960-3 may obtain a signal corresponding to motion by recognizing the user's motion (e.g., gesture recognition), and may provide a display corresponding to the signal to the at least one display 1950. The processor may identify a signal corresponding to the operation and may perform a preset function based on the identification. The motion recognition camera 1960-2 and 1960-3 may be used to perform simultaneous localization and mapping (SLAM) for 6 degrees of freedom pose (6 dof pose) and/or a space recognition function using a depth map. The processor may perform a gesture recognition function and/or an object tracking function, by using the motion recognition camera 1960-2 and 1960-3. In an embodiment, the motion recognition camera 1960-2 and camera 1960-3 may be disposed on the first rim 1901 and/or the second rim 1902.

The camera 1960 included in the wearable device 1900 are not limited to the above-described eye tracking camera 1960-1 and the motion recognition camera 1960-2 and 1960-3. For example, the wearable device 1900 may identify an external object included in the FoV by using a camera disposed toward the user's FoV. The wearable device 1900 identifying the external object may be performed based on a sensor for identifying a distance between the wearable device 1900 and the external object, such as a depth sensor and/or a time of flight (ToF) sensor. The camera 1960 disposed toward the FoV may support an autofocus function and/or an optical image stabilization (OIS) function. For example, in order to obtain an image including a face of the user wearing the wearable device 1900, the wearable device 1900 may include the camera 1960 (e.g., a face tracking (FT) camera) disposed toward the face.

Although not illustrated, the wearable device 1900 according to an embodiment may further include a light source (e.g., LED) that emits light toward a subject (e.g., user's eyes, face, and/or an external object in the FoV) photographed by using the camera 1960. The light source may include an LED having an infrared wavelength. The light source may be disposed on at least one of the frame, and the hinge units 1906 and 1907.

According to an embodiment, the battery module 1970 may supply power to electronic components of the wearable device 1900. In an embodiment, the battery module 1970 may be disposed in the first temple 1904 and/or the second temple 1905. For example, the battery module 1970 may be a plurality of battery modules 1970. The plurality of battery modules 1970, respectively, may be disposed on each of the first temple 1904 and the second temple 1905. In an embodiment, the battery module 1970 may be disposed at an end of the first temple 1904 and/or the second temple 1905.

The antenna module 1975 may transmit the signal or power to the outside of the wearable device 1900 or may receive the signal or power from the outside. In an embodiment, the antenna module 1975 may be disposed in the first temple 1904 and/or the second temple 1905. For example, the antenna module 1975 may be disposed close to one surface of the first temple 1904 and/or the second temple 1905.

The speaker 1955 may output a sound signal to the outside of the wearable device 1900. A sound output module may be referred to as a speaker. In an embodiment, the speaker 1955 may be disposed in the first temple 1904 and/or the second temple 1905 in order to be disposed adjacent to the ear of the user wearing the wearable device 1900. For example, the speaker 1955 may include a second speaker 1955-2 disposed adjacent to the user's left ear by being disposed in the first temple 1904, and a first speaker 1955-1 disposed adjacent to the user's right ear by being disposed in the second temple 1905.

The light emitting module (not illustrated) may include at least one light emitting element. The light emitting module may emit light of a color corresponding to a specific state or may emit light through an operation corresponding to the specific state in order to visually provide information on a specific state of the wearable device 1900 to the user. For example, when the wearable device 1900 requires charging, it may emit red light at a constant cycle. In an embodiment, the light emitting module may be disposed on the first rim 1901 and/or the second rim 1902.

Referring to FIG. 19B, according to an embodiment, the wearable device 1900 may include the printed circuit board (PCB) 1990. The PCB 1990 may be included in at least one of the first temple 1904 or the second temple 1905. The PCB 1990 may include an interposer disposed between at least two sub PCBs. On the PCB 1990, one or more hardware (e.g., hardware illustrated by different blocks of FIG. 2) included in the wearable device 1900 may be disposed. The wearable device 1900 may include a flexible PCB (FPCB) for interconnecting the hardware.

According to an embodiment, the wearable device 1900 may include at least one of a gyro sensor, a gravity sensor, and/or an acceleration sensor for detecting the posture of the wearable device 1900 and/or the posture of a body part (e.g., a head) of the user wearing the wearable device 1900. Each of the gravity sensor and the acceleration sensor may measure gravity acceleration, and/or acceleration based on preset 3-dimensional axes (e.g., x-axis, y-axis, and z-axis) perpendicular to each other. The gyro sensor may measure angular velocity of each of preset 3-dimensional axes (e.g., x-axis, y-axis, and z-axis). At least one of the gravity sensor, the acceleration sensor, and the gyro sensor may be referred to as an inertial measurement unit (IMU). According to an embodiment, the wearable device 1900 may identify the user's motion and/or gesture performed to execute or stop a specific function of the wearable device 1900 based on the IMU.

FIGS. 20A to 20B illustrate an example of an exterior of a wearable device according to an embodiment. A wearable device 2000 of FIGS. 20A to 20B may include at least a portion of hardware of the wearable device 1900 described with reference to FIGS. 19A and/or 19B. According to an embodiment, an example of an exterior of a first surface 2010 of a housing of the wearable device 2000 may be illustrated in FIG. 20A, and an example of an exterior of a second surface 2020 opposite to the first surface 2010 may be illustrated in FIG. 20B.

Referring to FIG. 20A, according to an embodiment, the first surface 2010 of the wearable device 2000 may have an attachable shape on the user's body part (e.g., the user's face). Although not illustrated, the wearable device 2000 may further include a strap for being fixed on the user's body part, and/or one or more temples (e.g., the first temple 1904 and/or the second temple 1905 of FIGS. 19A to 19B). A first display 1950-1 for outputting an image to the left eye among the user's two eyes and a second display 1950-2 for outputting an image to the right eye among the user's two eyes may be disposed on the first surface 2010. The wearable device 2000 may further include rubber or silicon packing, which are formed on the first surface 2010, for preventing interference by light (e.g., ambient light) different from the light emitted from the first display 1950-1 and the second display 1950-2.

According to an embodiment, the wearable device 2000 may include a camera 1960-1 for photographing and/or tracking two eyes of the user adjacent to each of the first display 1950-1 and the second display 1950-2. The camera 1960-1 may be referred to as the gaze tracking camera 1960-1 of FIG. 19B. According to an embodiment, the wearable device 2000 may include cameras 1960-5 and 1960-6 for photographing and/or recognizing the user's face. The cameras 1960-5 and 1960-6 may be referred to as a FT camera. The wearable device 2000 may control an avatar representing a user in a virtual space, based on a motion of the user's face identified using the cameras 1960-5 and 1960-6. For example, the wearable device 2000 may change a texture and/or a shape of a portion (e.g., a portion of an avatar representing a human face) of the avatar, by using information obtained by the cameras 1960-5 and 1960-6 (e.g., the FT camera) and representing the facial expression of the user wearing the wearable device 2000.

Referring to FIG. 20B, a camera (e.g., cameras 1960-7, 1960-8, 1960-9, 1960-10, 1960-11, and 1960-12), and/or a sensor (e.g., the depth sensor 2030) for obtaining information associated with the external environment of the wearable device 2000 may be disposed on the second surface 2020 opposite to the first surface 2010 of FIG. 20A. For example, the cameras 1960-7, 1960-8, 1960-9, and 1960-10 may be disposed on the second surface 2020 in order to recognize an external object. The cameras 1960-7, 1960-8, 1960-9, and 1960-10 of FIG. 20B may correspond to as the motion recognition cameras 1960-2 and 1960-3 of FIG. 19B.

For example, by using cameras 1960-11 and 1960-12, the wearable device 2000 may obtain an image and/or video to be transmitted to each of the user's two eyes. The camera 1960-11 may be disposed on the second surface 2020 of the wearable device 2000 to obtain an image to be displayed through the second display 1950-2 corresponding to the right eye among the two eyes. The camera 1960-12 may be disposed on the second surface 2020 of the wearable device 2000 to obtain an image to be displayed through the first display 1950-1 corresponding to the left eye among the two eyes. The cameras 1960-11 and 1960-12 may correspond to as the photographing camera 1960-4 of FIG. 19B.

According to an embodiment, the wearable device 2000 may include the depth sensor 2030 disposed on the second surface 2020 in order to identify a distance between the wearable device 2000 and the external object. By using the depth sensor 2030, the wearable device 2000 may obtain spatial information (e.g., a depth map) about at least a portion of the FoV of the user wearing the wearable device 2000. Although not illustrated, a microphone for obtaining sound outputted from the external object may be disposed on the second surface 2020 of the wearable device 2000. The number of microphones may be one or more according to embodiments.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 1740) including one or more instructions that are stored in a storage medium (e.g., internal memory 1736 or external memory 1738) that is readable by a machine (e.g., the electronic device 1701). For example, a processor (e.g., the processor 1720) of the machine (e.g., the electronic device 1701) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. A display panel (410), comprising:
a substrate (401);
a switching circuit (491) formed on the substrate (401);
a first conductive pad (402) and a second conductive pad (402-3) connected to the switching circuit (491) and formed on the substrate;
a first light emitting diode (LED) (420) including a first electrode (421) connected to the first conductive pad (402), a light emitting element (423) disposed on the first electrode (421), and a second electrode (422) disposed on the light emitting element (423);
a second LED (420) including a third electrode (421-3) connected to the second conductive pad (402-3), a light emitting element (423-3) disposed on the third electrode (421-3), and a fourth electrode (423-4) disposed on the light emitting element (423-3); and
an insulating member (1310, 1501) disposed between the first LED (420) and the second LED (420),
wherein a height of the insulating member (1310, 1501) is greater than a height of the first conductive pad (402), and the height of the insulating member (1310, 1501) is lower than a height of the first LED coupled to the first conductive pad (402).

2. The display panel (410) of claim 1, further comprising an additional insulating member (1602) disposed on the insulating member disposed on the substrate.

3. The display panel (410) of claim 2, wherein a sum of the height of the insulating member and a height of the additional insulating member is greater than the height of the first LED (420) coupled to the first conductive pad.

4. The display panel (410) according to any one of claims 2 to 3, wherein the insulating member (1310, 1501) and the additional insulating member surround the first LED (420) along a side surface of the first LED (420).

5. The display panel (410) of claim 4, further comprising a color conversion material disposed in a space surrounded by the insulating member (1310, 1501).

6. The display panel (410) according to any one of claims 1 to 5, wherein a color of light emitted from the first LED (420) and the second LED (420) is the same.

7. The display panel (410) according to any one of claims 1 to 6, wherein the insulating member (1310, 1501) has a concave-convex shape and is spaced apart from the first LED (420) and the second LED (420).

8. The display panel (410) according to any one of claims 1 to 7, wherein the first LED is disposed adjacent to the second LED.

9. The display panel (410) according to any one of claims 1 to 8, wherein the second electrode and the fourth electrode include a transparent material configured to transmit light emitted from the light emitting element of the first LED and the light emitting element of the second LED, respectively.

10. The display panel (410) according to any one of claims 1 to 9, further comprising an additional transparent substrate disposed on the second electrode and the fourth electrode and configured to connect each of the second electrode and the fourth electrode to a switching circuit.

11. A display panel (410), comprising:
a substrate (401);
a switching circuit (491) formed on the substrate;
a conductive pad connected to the switching circuit (491) and formed on the substrate; and
an LED (420) including a first electrode (421) connected to the conductive pad (402), a light emitting element (423) disposed on the first electrode (421), and a second electrode (422) disposed on the light emitting element (423),
wherein the conductive pad (402) includes partial pads spaced apart from each other, and
wherein the conductive pad (402) is coupled to the first electrode by a conductive material disposed between the partial pads.

12. The display panel (410) of claim 11, wherein a melting point of the conductive material is lower than a melting point of the partial pads of the conductive pad (402).

13. The display panel (410) of claim 11 or 12, wherein one of the partial pads is connected to a wiring connected to the switching circuit.

14. The display panel (410) according to any one of claims 11 to 13, further comprising a transparent conductive layer disposed on the second electrode and configured to electrically connect the switching circuit and the second electrode.

15. The display panel (410) according to any one of claims 11 to 14, wherein the second electrode includes a transparent material configured to transmit light emitted from the light emitting element to the outside.
